# EUROPÄISCHE PATENTSCHRIFT

(11) **EP 3 214 694 B1**
(45) Veröffentlichungstag und Bekanntmachung des Hinweises auf die Patenterteilung: **17.10.2018**
(21) Anmeldenummer: 17156830.6
(22) Anmeldetag: 20.02.2017
(51) Int. Cl.: H05K 5/00, H01Q 1/12, H01Q 1/42, H01Q 1/50, H01Q 21/00, H01Q 1/24

(54) **MODULARE GEHÄUSEANORDNUNG FÜR ANTENNEN**
MODULAR HOUSING ASSEMBLY FOR ANTENNAS
SYSTÈME DE BOÎTIER MODULAIRE POUR ANTENNES

(30) Priorität: 04.03.2016 DE 102016104000
(43) Veröffentlichungstag der Anmeldung: 06.09.2017
(73) Patentinhaber: Kathrein-Werke KG, 83022 Rosenheim (DE)
(72) Erfinder: Fahrenschon, Josef, 83026 Rosenheim (DE); Schadeck, Alexander, 83233 Bernau am Chiemsee (DE)
(74) Vertreter: Flach Bauer Stahl Patentanwälte Partnerschaft mbB

(56) Entgegenhaltungen:
- DE-A1- 3 004 271
- DE-U1- 29 800 502

## Beschreibung

Die hier vorliegende Erfindung betrifft eine modulare Gehäuseanordnung für Antennen, die insbesondere zur bidirektionalen mobilen Kommunikation eingesetzt werden kann. Mit einer solchen Antenne werden bestimmte Gebiete ausgeleuchtet, also mit Sprach- und/oder Datendiensten versorgt. Hierzu werden die Antennen, geschützt durch Radome, bevorzugt an möglichst hohen Masten montiert, um ein möglichst großes Gebiet zu versorgen. An einem einzelnen Mast sind Antennen unterschiedlicher Mobilfunkanbieter montiert, die auf unterschiedlichen Frequenzbereichen betrieben werden.

Problematisch ist allerdings die Versorgung von Innenstätten, wo das Signal an Fassaden mehrfach reflektiert wird und wo mit einer sehr hohen Teilnehmeranzahl zu rechnen ist. Die mit einer Antenne zu versorgenden Gebiete sollen hier teilweise kleiner gehalten werden. Gleichzeitig stören große Antennen in Innenstätten das Stadtbild mehr als im Umland.

Aus der DE 298 00 502 U1 ist eine Gehäuseanordnung bekannt, die aus zwei separaten Gehäusen besteht. Jedes Gehäuse umfasst jeweils ein Anschlussteil. Ein Adapterstück ist über eine erste Seite mit dem Anschlussteil des ersten Gehäuses verbindbar und eine zweite Seite mit dem Anschlussteil des zweiten Gehäuses. Dies gelingt über eine Rastverbindung. Hierfür ist an den Anschlussteilen jeweils ein männlicher Teil und an dem Adapterstück ein weiblicher Teil vorhanden.

Aus der DE 30 04 271 A1 ist ein modulares Gehäuse für DIN-Verteilerkästen bekannt. Das Aufnahmevolumen dieses Gehäuses ist anpassbar. Hierzu sind der Boden und die Deckeleinheiten aus rastbaren Einzelelementen geeigneter Größe zu dem gesamten modularen Gehäuses zusammengesetzt.

Es ist daher die Aufgabe der vorliegenden Erfindung, eine modulare Gehäuseanordnung für Antennen zu schaffen, die insbesondere in städtischen Bereichen eingesetzt werden kann, wobei diese die vorhergehenden Probleme beheben und möglichst einfach zu installieren sein soll. Weiterhin soll das Antennensystem für verschiedene Anbieter beliebig und möglichst einfach erweiterbar sein.

Die hier vorliegende Aufgabe wird durch die erfindungsgemäße modulare Gehäuseanordnung für Antennen gemäß dem unabhängigen Anspruch 1 gelöst. In den Unteransprüchen sind vorteilhafte Weiterbildungen der Erfindung angegeben.

Die erfindungsgemäße modulare Gehäuseanordnung für Antennen sieht zumindest ein Antennengehäuse (auch Radom genannt) vor, das eine deckelseitige Stirnseite, eine bodenseitige Stirnseite und eine zwischen der deckelseitigen Stirnseite und der bodenseitigen Stirnseite umlaufende Seitenwand mit mehreren Seitenflächen umfasst, wodurch ein Aufnahmeraum definiert ist. In dem Aufnahmeraum ist zumindest eine Antenne angeordnet oder anordenbar. An der umlaufenden Seitenwand bzw. an zumindest einer, vorzugsweise an allen Seitenflächen der umlaufenden Seitenwand, sind zumindest ein männlicher und ein weiblicher Teil einer Form- und/oder Kraftschlussverbindung, insbesondere in Form einer Schnappverbindung versetzt zueinander angeordnet. Das zumindest eine männliche Teil und das zumindest eine weibliche Teil sind dazu ausgebildet, eine zerstörungsfreie und werkzeugfreie lösbare Form- und/oder Kraftschlussverbindung mit einem dazu korrespondierenden weiblichen bzw. männlichen Teil zumindest eines weiteren Antennengehäuses und/oder zumindest eines Verbindungselements herzustellen. In einer ersten Alternative ist das zumindest eine männliche Teil dabei stiftförmig oder näherungsweise stiftförmig ausgebildet, wohingegen das zumindest eine weibliche Teil aus einem U- und/oder klammerförmigen Aufnahmeelement oder aus zumindest zwei in Axialrichtung voneinander beabstandeten U- und/oder klammerförmigen Aufnahmeelementen besteht, wobei jedes U- und/oder klammerförmige Aufnahmeelement aus zwei elastischen Halteschenkeln besteht, durch die das zumindest eine männliche Teil formschlüssig haltbar ist oder gehalten ist. In einer zweiten Alternative umfasst die lösbare Form- und/oder Kraftschlussverbindung eine Gelenkverbindung.

Besonders vorteilhaft ist dabei, dass mehrere Antennengehäuse durch eine Form- und/oder Kraftschlussverbindung, insbesondere in Form einer Schnappverbindung bzw. Klickverbindung beliebig miteinander verbunden werden können. Dadurch ist es möglich, dass zu Beginn der Installation der modularen Gehäuseanordnung sehr einfach die notwendigen Antennengehäuse montiert werden können. Auch nach einer bereits erfolgten Installation kann die modulare Gehäuseanordnung - wie der Name modular schon sagt - sehr einfach erweitert werden, indem ein neues Antennengehäuse dazu geclipst wird. Werkzeuge sind hierfür nicht notwendig, so dass sich die Installation deutlich vereinfacht. Die modulare Gehäuseanordnung kann dabei in und/oder an bzw. auf "Stadtmöbeln", wie Bushäuschen, öffentlichen Toiletten, Werbetafeln, Informationstafeln, Kiosken, Fahrkartenautomaten, Litfaßsäulen usw. montiert werden. Die einzelnen Antennengehäuse können dabei an unterschiedliche Mobilfunkanbieter vermietet werden. Über die einzelnen Antennengehäuse können die üblichen Kommunikationsstandards wie GSM, UMTS, LTE angeboten werden. Es kann auch eine W-LAN Verbindung bereitgestellt werden, die beispielsweise von der Stadt oder einem werbenden Unternehmen zu Verfügung gestellt wird. Es ist auch möglich, dass einige Antennen als Repeater dienen, wodurch auf eine kabelgebundene Versorgung der Antennen der modularen Gehäuseanordnung verzichtet werden kann. Die modulare Gehäuseanordnung kann daher sehr einfach je nach Bedarf erweitert bzw. rückgebaut werden.

Vorzugsweise sind die männlichen Teile zumindest hinsichtlich der Anordnung oder Abmessungen ihrer Kontaktstellen, also den Stellen, die in das weibliche Teil eingreifen, identisch zueinander ausgebildet. Ein Monteur muss in diesem Fall nicht zuerst prüfen, wie er das eine Antennengehäuse mit dem anderen Antennengehäuse oder mit einem Verbindungselement verbinden kann.

Vorzugsweise ist dabei das zumindest eine Antennengehäuse einteilig mit allen männlichen und weiblichen Teilen, die an diesem angeordnet sind, ausgebildet. Das zumindest eine Antennengehäuse besteht vorzugsweise aus Kunststoff und wird in einem Spritzgussverfahren hergestellt. Die deckelseitige Stirnseite ist vorzugsweise verschlossen. Ein solcher Verschluss kann direkt beim Herstellen des Antennengehäuses geschaffen werden, so dass das Antennengehäuse zusammen mit der verschlossenen deckelseitigen Stirnseite einteilig ausgebildet ist. Ein solcher Verschluss kann allerdings auch in Form einer Abdeckung realisiert sein, die später, also nach der Herstellung, aufgesetzt wird. Die bodenseitige Stirnseite ist vorzugsweise vollständig oder teilweise geöffnet, so dass das Anschlusskabel bzw. die Steckverbindung für das Anschlusskabel für die in dem Antennengehäuse angeordnete Antenne herausgeführt werden kann.

In einer Weiterbildung der modularen Gehäuseanordnung weist das zumindest eine Antennengehäuse die Form eines n-Ecks mit n ≥ 4 auf, wobei an den meisten oder allen der n-Seitenflächen der umlaufenden Seitenwand zumindest ein männliches Teil und zumindest ein weibliches Teil der Form- und/oder Kraftschlussverbindung in Umlaufrichtung versetzt zueinander angeordnet sind. Das männliche und das weibliche Teil sind dabei an jeder Seitenfläche identisch angeordnet, so dass das Antennengehäuse beliebig gedreht werden kann.

Im Einsatz umfasst die modulare Gehäuseanordnung vorzugsweise zumindest zwei Antennengehäuse, die über die jeweiligen männlichen und weiblichen Teile der Form- und/oder Kraftschlussverbindung mittelbar oder unmittelbar miteinander verbindbar oder verbunden sind, wobei Ebenen der deckelseitigen Stirnseiten der einzelnen Antennengehäuse in einem Winkel von 0°, 90° und/oder 180° zueinander angeordnet sind. Dies bedeutet, dass die einzelnen Antennengehäuse durch die gleiche Ebene verlaufen oder um 90° versetzt zueinander angeordnet sind, so dass unterschiedliche Straßen ausgeleuchtet werden oder dass die einzelnen Antennengehäuse um 180° versetzt zueinander angeordnet werden, so dass ein vorderer und ein hinterer Teil einer Straße ausgeleuchtet wird. Andere Winkellagen wie zum Beispiel 120° sind ebenfalls denkbar.

Für den Fall, dass beide Antennengehäuse unmittelbar miteinander verbunden sind, greift zumindest ein männliches Teil jeder der beiden Antennengehäuse in ein dazu korrespondierendes weibliches Teil am anderen Antennengehäuse ein. In diesem Fall ist der Abstand zwischen den einzelnen Antennengehäusen minimal. Der Abstand sollte in diesem Fall so gewählt sein, dass ein MIMO-Betrieb (engl. Multiple Input Multiple Output) der zumindest beiden Antennengehäuse mit den jeweiligen Antennen möglich ist.

Die einzelnen Antennengehäuse können allerdings auch nur mittelbar miteinander verbunden werden. In diesem Fall sind beide Antennengehäuse mit vorzugsweise dem gleichen Verbindungselement verbunden, bei welchem es sich in diesem Fall um einen Abstandshalter handelt. Der Abstandshalter weist zwei gegenüberliegende Seitenflächen auf, wobei auf jeder Seitenfläche zumindest ein männliches Teil und zumindest ein weibliches Teil einer Form- und/oder Kraftschlussverbindung versetzt zueinander angeordnet sind. Beide Seitenflächen des Abstandshalters sind durch ein Zwischenteil voneinander beabstandet, wobei der Abstandshalter zusammen mit dem Zwischenteil vorzugsweise einteilig ausgebildet ist. Ein solcher Abstandshalter wird eingesetzt, wenn die dadurch miteinander verbundenen Antennengehäuse beispielsweise von verschiedenen Mobilfunkanbietern betrieben werden bzw. wenn kein MIMO-Betrieb vorgesehen ist. Der Abstandhalter ist hinsichtlich seiner Abmessung so bemessen, dass sich die einzelnen Antennen innerhalb der zumindest beiden Antennengehäuse möglichst wenig beeinflussen. Der durch den Abstandshalter genau definierte Abstand zwischen den einzelnen Antennengehäusen dient auch der Entkopplung.

Um die modulare Gehäuseanordnung weiter zu verstärken, sieht ein weiteres Ausführungsbeispiel den Einsatz von zumindest einem Verbindungselement in Form eines Verstärkungselements vor. Das Verstärkungselement weist an einer ersten Seitenfläche zumindest ein männliches Teil und zumindest ein weibliches Teil einer Form- und/oder Kraftschlussverbindung auf, die versetzt zueinander angeordnet sind. Das Verstärkungselement kann dabei lediglich mit einer Seitenfläche des Antennengehäuses, also mit genau einem Antennengehäuse verbunden sein. Es kann allerdings auch mit zwei benachbarten Antennengehäusen verbunden sein, wobei das männliche Teil des Verstärkungselements in das weibliche Teil eines ersten Antennengehäuses und das weibliche Teil des Verstärkungselements in das männliche Teil des anderen Antennengehäuses eingreift.

Das Verstärkungselement kann an einer ersten Stirnseite zusätzlich ein männliches Teil und an einer zweiten Stirnseite zusätzlich ein weibliches Teil einer Form- und/oder Kraftschlussverbindung aufweisen. Dadurch ist es möglich, dass zwei Verstärkungselemente unmittelbar oder mittelbar miteinander verbunden werden. Eine unmittelbare Verbindung kann beispielsweise dann erfolgen, wenn die beiden Antennengehäuse ohne den Einsatz eines Abstandshalters unmittelbar miteinander verbunden sind. In diesem Fall kann jedes Verstärkungselement ausschließlich an einer Seitenfläche der Seitenwand jedes Antennengehäuses eingreifen, wobei die beiden Verstärkungselemente an ihrer Stirnseite zusätzlich miteinander verbunden sind. Für den Fall, dass die beiden Antennengehäuse lediglich mittelbar miteinander verbunden sind, also durch einen Abstandshalter voneinander beabstandet sind, kann das männliche bzw. weibliche Teil an der jeweiligen Stirnseite beider Verstärkungselemente in das dazu korrespondierende männliche bzw. weibliche Teil an der Stirnseite eines Zwischenverbinders eingreifen, worüber die beiden Verstärkungselemente mittelbar miteinander verbunden sind.

Es ist auch möglich, dass es sich bei dem Verbindungselement um einen Winkelverbinder handelt, der an seiner ersten Stirnseite ein männliches und an seiner zweiten Stirnseite ein weibliches Teil einer Form- und/oder Kraftschlussverbindung aufweist. Der zumindest eine Winkelverbinder wird mit seiner ersten Stirnseite mit einem Verstärkungselement verbunden, wohingegen der Winkelverbinder mit seiner zweiten Stirnseite in ein männliches bzw. weibliches Teil einer weiteren Seitenfläche der umlaufenden Seitenwand des Antennengehäuses eingreift. Die weitere Seitenfläche ist zu der Seitenfläche der umlaufenden Seitenwand unmittelbar benachbart, an der das Verstärkungselement eingreift. Über einen Winkelverbinder können zusammen mit einem Verstärkungselement zwei direkte benachbarte Seitenflächen der umlaufenden Seitenwand des Antennengehäuses miteinander verbunden werden.

Besonders vorteilhaft ist es außerdem, wenn das Verstärkungselement an der Seitenfläche zumindest zwei versetzt zueinander angeordnete männliche und/oder zumindest zwei versetzt zueinander weibliche Teile einer Form- und/oder Kraftschlussverbindung aufweist. In Abhängigkeit davon, ob die beiden Antennengehäuse mittelbar oder unmittelbar miteinander verbunden sind, gelangt das eine oder das andere der zumindest beiden männlichen oder weiblichen Teile in Eingriff mit dem jeweiligen Gegenstück. Dadurch kann ein Verstärkungselement eingesetzt werden, welches zwei Antennengehäuse miteinander an deren umlaufender Seitenwand verbindet und zwar unabhängig davon, ob die beiden Antennen jeweils mittelbar oder unmittelbar miteinander verbunden sind.

Daneben ist es auch möglich, dass die deckelseitigen Stirnseiten, also die Seiten, an welchen die in den Antennengehäusen angeordneten Antennen abstrahlen, nicht in die gleiche Richtung zeigen. Es ist daher auch möglich, dass zwei Antennengehäuse mit ihren bodenseitigen Stirnseiten in Abstand zueinander angeordnet und aufeinanderzu gerichtet sind. Die einzelnen Antennengehäuse sind in diesem Fall um 180° versetzt zueinander angeordnet.

In diesem Fall kann ein Verbindungselement in Form einer Verbindungsplatte eingesetzt werden, die senkrecht zu den beiden deckelseitigen Stirnseiten angeordnet ist. Die Verbindungsplatte weist zumindest zwei männliche und zumindest zwei weibliche Teile einer Form- und/oder Kraftschlussverbindung auf, wobei diese in die korrespondierenden Gegenstücke an den ersten und an dem zweiten Antennengehäuse eingreifen.

Das zumindest eine Antennengehäuse ist mit dem zumindest einen männlichen und weiblichen Teil der Form- und/oder Kraftschlussverbindung auch an korrespondierenden Teilen einer Grundstruktur und/oder Trägerplatte befestigbar, die Teil einer Gebäudestruktur ist und zur Befestigung an den "Stadtmöbeln" dient. Für den Fall, dass die "Stadtmöbel" selbst direkt an ihrer Oberfläche ein männliches und ein weibliches Teil einer solchen Form- und/oder Kraftschlussverbindung aufweisen, kann das zumindest eine Antennengehäuse beispielsweise direkt mit dem Dach eines Bushäuschens verbunden werden.

Um das Stadtbild zu wahren, ist es in diesem Fall vorteilhaft, wenn die modulare Gehäuseanordnung noch ein Außengehäuse umfasst. Das Außengehäuse umgibt in diesem Fall alle Antennengehäuse gemeinsam und kann beispielsweise in der Farbe der umgebenden Objektstruktur gehalten sein.

Verschiedene Ausführungsbeispiele der Erfindung werden nachfolgend unter Bezugnahme auf die Zeichnungen beispielhaft beschrieben. Gleiche Gegenstände weisen dieselben Bezugszeichen auf. Die entsprechenden Figuren der Zeichnungen zeigen im Einzelnen:
- Figuren 1A bis 1D:: verschiedene Darstellungen eines Antennengehäuses der erfindungsgemäßen modularen Gehäuseanordnung;
- Figuren 2, 3A, 3B:: eine Verbindungsplatte und deren Anordnung an zwei um 180° versetzt zueinander liegenden Antennengehäusen;
- Figuren 4A, 4B, 5:: eine unmittelbare Verbindung von mehreren Antennengehäusen, sowie gleichzeitig der Einsatz eines Verstärkungselements und eines Winkelverbinder;
- Figur 6:: eine doppelte Anordnung von 2x2 Antennengehäusen, die in zwei entgegengesetzte Richtungen Signale aussenden;
- Figuren 7, 8:: den Einsatz eines Abstandshalters;
- Figur 9:: ein Ausführungsbeispiel eines Winkelverbinders;
- Figur 10:: ein Ausführungsbeispiel eines Zwischenverbinders;

- Figuren 11 bis 13B:: verschiedene Ausführungsformen der modularen Gehäuseanordnung; und
- Figuren 14A bis 14C:: verschiedene Ausführungsformen der modularen Gehäuseanordnung, wobei die einzelnen Antennengehäuse zueinander gedreht angeordnet sind.

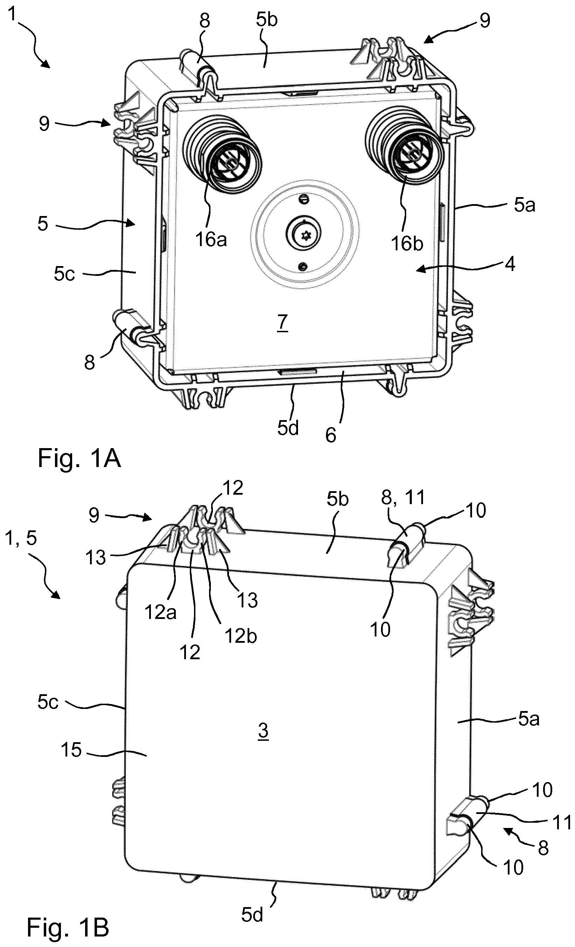

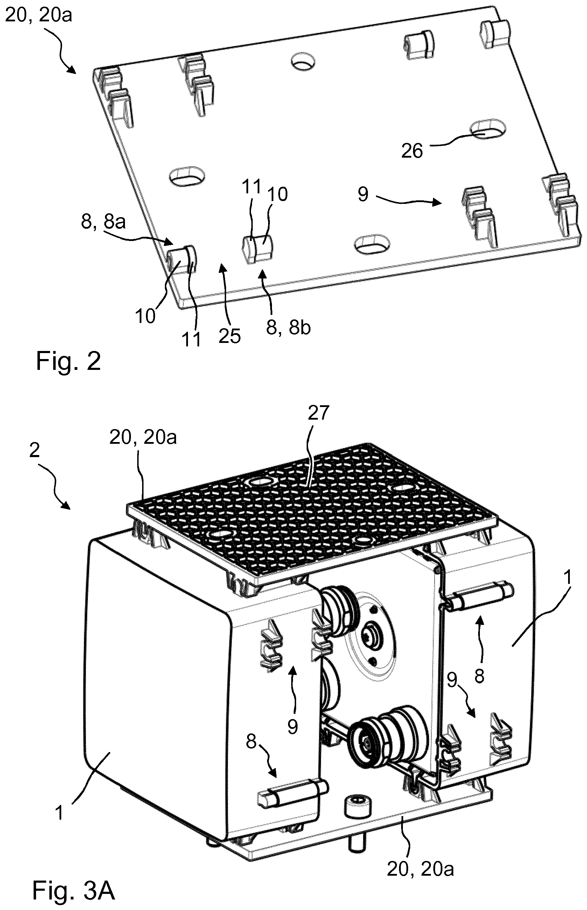

Die Figuren 1A und 1B zeigen ein Antennengehäuse 1 einer modularen Gehäuseanordnung 2 in verschiedenen Darstellungen. Das Antennengehäuse 1 umfasst eine deckelseitige Stirnseite 3 und eine bodenseitige Stirnseite 4. Zwischen der deckelseitigen Stirnseite 3 und der bodenseitigen Stirnseite 4 ist eine umlaufende Seitenwand 5 mit mehreren Seitenflächen 5a, 5b, 5c, 5d angeordnet, wodurch ein Aufnahmeraum 6 definiert ist. Zumindest eine Antenne 7 ist in dem Aufnahmeraum 6 angeordnet oder anordenbar. An der umlaufenden Seitenwand 5 sind zumindest ein männliches Teil 8 und ein weibliches Teil 9 einer Form- und/oder Kraftschlussverbindung in Form einer Schnappverbindung in Umlaufrichtung versetzt zueinander angeordnet. Das zumindest eine männliche Teil 8 und das zumindest eine weibliche Teil 9 sind dazu ausgebildet, eine lösbare Schnappverbindung mit einem dazu korrespondierenden weiblichen bzw. männlichen Teil 9, 8 zumindest eines weiteren Antennengehäuses 1 und/oder zumindest eines Verbindungselements 20 (ab Figur 2) herzustellen.

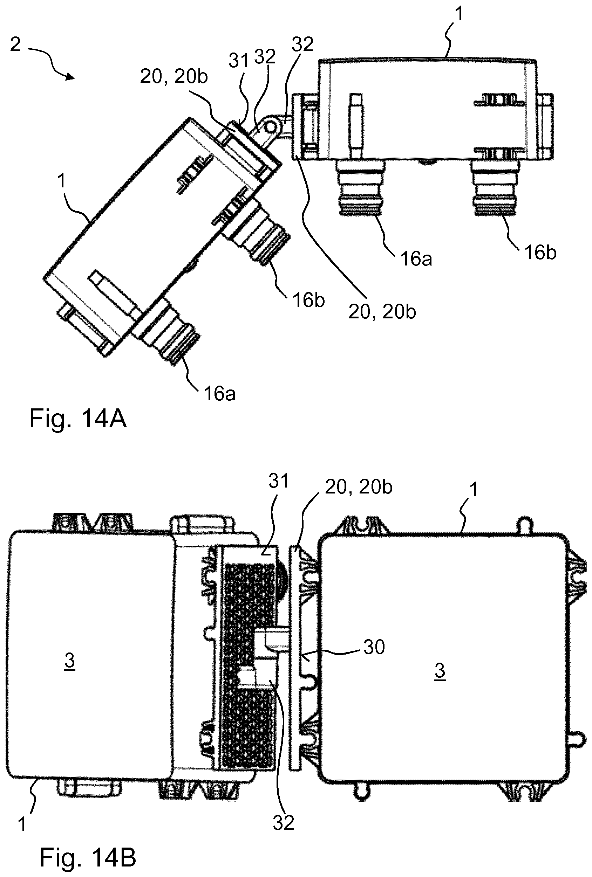

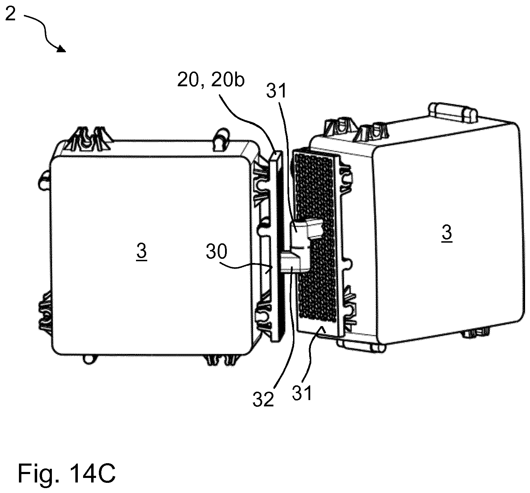

In den Zeichnungen werden mit Ausnahme der Figuren 14A bis 14C lediglich Form- und/oder Kraftschlussverbindungen in Form von Schnappverbindungen bzw. Klickverbindungen gezeigt. Es ist aber klar, dass es sich bei den Form- und/oder Kraftschlussverbindungen auch um Schiebeverbindungen oder Steckverbindungen oder Bajonettverbindungen oder Gelenkverbindungen handeln kann. Die verschiedenen Arten von Verbindungen können in der modularen Gehäuseanordnung 2 auch gemischt auftreten.

Das zumindest eine männliche Teil 8 ist stiftförmig oder näherungsweise stiftförmig ausgebildet. Er ist vorzugsweise ein integraler Bestandteil des Antennengehäuses 1. Das stiftförmige oder näherungsweise stiftförmig ausgebildete zumindest eine männliche Teil 8 weist an seinen Kontaktstellen 10, die mit dem weiblichen Teil 9 in Kontakt bringbar oder gebracht sind, einen kleineren Durchmesser auf, als in den dazu axial benachbarten Stellen 11, wodurch eine relative axiale Verschiebung zwischen dem männlichen Teil 8 und dem weiblichen Teil 9 vermieden wird.

Vorzugsweise sind alle männlichen Teile 8 hinsichtlich ihrer Anordnung und den Abmessungen ihrer Kontaktstellen 10 identisch zueinander aufgebaut. Vorzugsweise sind alle männlichen Teile 8 aller Antennengehäuse 1 insgesamt identisch zueinander aufgebaut und bevorzugt an den jeweils gleichen Stellen an den verschiedenen Antennengehäusen 1 angeordnet.

Das zumindest eine männliche Teil 8 ist in Hinblick auf Figur 1B weiter von der deckelseitigen Stirnseite 3 weg angeordnet als von der bodenseitigen Stirnseite 4. Es wäre auch möglich, dass das männliche Teil 8 gleich weit von der bodenseitigen Stirnseite 4 entfernt angeordnet ist wie von der deckelseitigen Stirnseite 3. Es könnte auch näher an der deckelseitigen Stirnseite 3 angeordnet sein. Gleiches gilt auch für das zumindest eine weibliche Teil 9.

Das zumindest eine weibliche Teil 9 ist derart ausgebildet, dass dieses zusammen mit dem männlichen Teil 8 eine formschlüssige Verbindung eingehen kann. Das zumindest eine weibliche Teil 8 besteht aus einem U- und/oder klammerförmigen Aufnahmeelement 12 oder aus zwei in Axialrichtung voneinander beabstandeten U- und/oder klammerförmigen Aufnahmeelementen 12. Jedes U- und/oder klammerförmige Aufnahmeelement 12 besteht aus zwei elastischen Halteschenkeln 12a, 12b, durch die das zumindest eine männliche Teil 8 formschlüssig haltbar oder gehalten ist. Die Halteschenkel 12a, 12b können zumindest teilweise voneinander wegbewegt werden. Der Abstand zwischen den Halteschenkeln 12a, 12b ist daher veränderlich. Die Halteschenkel 12a, 12b sind zumindest teilweise elastisch. Beim Einführen des männlichen Teils 8 der Schnappverbindung werden die beiden Halteschenkel 12a, 12b des weiblichen Teils 9 der Schnappverbindung geringfügig auseinander gedrückt. Damit die Halteschenkel 12a, 12b nicht abbrechen sind vorzugsweise zusätzlich Schnappschutzelemente 13 angeordnet. Diese Schnappschutzelemente 13 sind benachbart zu den jeweiligen Halteschenkeln 12a, 12b angebracht und begrenzen den Winkel, um den sich die Halteschenkel 12a, 12b auseinander bewegen können. Die Schnappschutzelemente 13 sind im einfachsten Fall als Vorsprung ausgebildet. Dabei sind die Schnappschutzelemente 13 zusammen mit den Halteschenkeln 12a, 12b vorzugsweise einteilig mit dem Antennengehäuse 1 ausgebildet.

In den Figuren 1A und 1B umfasst jede Seitenfläche 5a, 5b, 5c, 5d der umlaufenden Seitenwand 5 ein männliches Teil 8 und ein weibliches Teil 9. Der Abstand zwischen dem männlichen Teil 8 und dem weiblichen Teil 9 ist für alle männlichen bzw. weiblichen Teile 8, 9 aller Antennengehäuse 1 identisch. Gleiches gilt auch für den Abstand zwischen den einzelnen Kontaktstellen 10 des männlichen Teils 8. Dieser Abstand ist für alle männlichen Teile 8, egal an welchen Gegenständen sie angebracht sind, identisch. Dadurch ist gewährleistet, dass die einzelnen Komponenten, wie beispielsweise die einzelnen Antennengehäuse 1, sehr einfach miteinander verbunden werden können.

Das zumindest eine Antennengehäuse 1 weist vorzugsweise die Form eines n-Ecks mit n = 4 auf, wobei an den meisten oder vorzugsweise an allen der n Seitenflächen 5a, 5b, 5c, 5d der umlaufenden Seitenwand 5 zumindest ein männliches Teil 8 und zumindest ein weibliches Teil 9 der Schnappverbindung in Umlaufrichtung versetzt zueinander angeordnet sind. Es wäre auch möglich, dass es sich um ein Fünfeck oder um ein Sechseck handelt, mit n ≥ 4. Die Anordnung als Viereck ist allerdings die bevorzugte Ausführungsvariante.

Im Hinblick auf Figur 1B ist zu erkennen, dass das Antennengehäuse 1 an der deckelseitigen Stirnseite 3 vollständig mit einer Abdeckung 15 verschlossen ist. Es ist auch möglich, dass die Abdeckung 15 die deckelseitige Stirnseite 3 nur überwiegend verschließt. Im Hinblick auf Figur 1A ist dagegen zu erkennen, dass die bodenseitige Stirnseite 4 überwiegend oder vollständig geöffnet ist. Dies erlaubt das Einsetzen der Antenne 7. Die Antenne 7 weist in dem Ausführungsbeispiel zwei Steckverbindungen 16a, 16b auf, mit denen die Antenne 7 mit einer übergeordneten Einrichtung (z.B. Verstärker, Filter) verbunden werden kann. Diese übergeordnete und nicht dargestellte Einrichtung ist für die Erzeugung des Hochfrequenzsignals und die Versorgung der Antenne 7 zuständig.

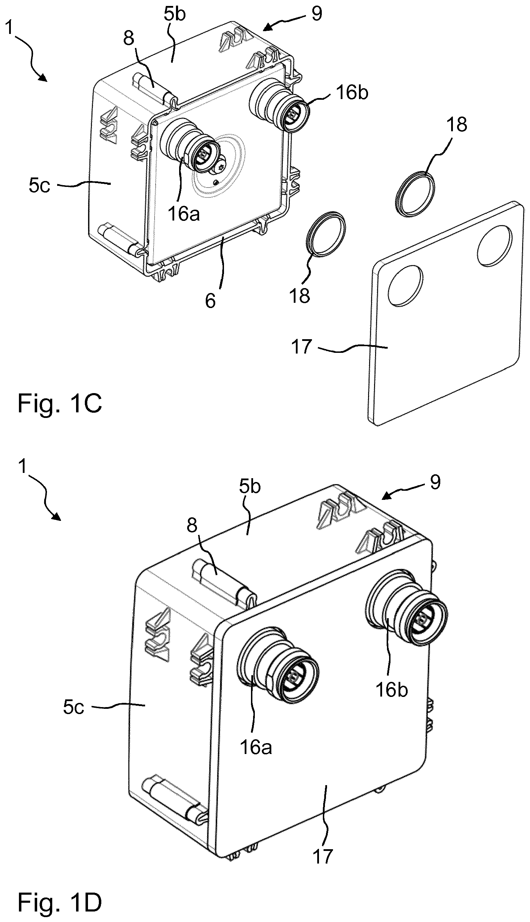

Mit Hinblick auf die Figuren 1C und 1D ist zu erkennen, dass die bodenseitige Stirnseite 4 mit einer weiteren Abdeckung 17 verschlossen werden kann. Die jeweiligen Steckverbindungen 16a, 16b werden durch diese weitere Abdeckung 17 hindurch geführt. Vorzugsweise sorgen außerdem Dichtringe 18 dafür, dass keine Feuchtigkeit in den Aufnahmeraum 6 des Antennengehäuses 1 eindringen kann. Durch Anbringung der weiteren Abdeckung 17 und der optionalen Dichtringe 18 an den Steckverbindungen 16a, 16b wird der Schutzgrad des Antennengehäuses 1 erhöht.

Das Antennengehäuse 1 ist in Axialrichtung weniger tief als es breit bzw. hoch ist.

Figur 2 zeigt ein Verbindungselement 20 in Form einer Verbindungsplatte 20a. Im Hinblick auf Figur 3A ist der Einsatz der Verbindungsplatte 20a gezeigt. Die Verbindungsplatte 20a wird dann eingesetzt, wenn zwei Antennengehäuse 1 mit ihren bodenseitigen Stirnseiten 4 zueinander angeordnet und aufeinander zu gerichtet sind. Eine solche Konfiguration wird auch Rücken-an-Rücken-Konfiguration (engl. back-to-back) genannt. Die Abstrahlrichtungen beider Antennengehäuse 1 sind dabei um 180° versetzt zueinander angeordnet. Die Verbindungsplatte 20a dient zum Fixieren der beiden Antennengehäuse 1 hinsichtlich ihrer Ausrichtung zueinander. In Figur 3A sind zwei Verbindungsplatten 20a zu erkennen, die senkrecht zu den beiden deckelseitigen Stirnseiten 3 angeordnet sind. Jede Verbindungsplatte 20a verbindet zwei Seitenflächen 5a, 5b, 5c, 5d zweier Antennengehäuse 1 miteinander, wobei die beiden Seitenflächen 5a, 5b, 5c, 5d in der gleichen Ebene liegen.

Im Hinblick auf Figur 2 weist die Verbindungsplatte 20a zumindest zwei männliche und zwei weibliche Teile 8, 9 einer Schnappverbindung auf. Ein männliches Teil 8 des ersten Antennengehäuses 1 greift in das weibliche Teil 9 der Verbindungsplatte 20a ein. Ein männliches Teil 8 des zweiten Antennengehäuses 1 greift in das weibliche Teil 9 der Verbindungsplatte 20a ein. Je ein männliches Teil 8 der Verbindungsplatte 20a greift in je ein weibliches Teil 9 des ersten und zweiten Antennengehäuses 1 ein. Dies bedeutet, dass die Verbindungsplatte 20a mittels zumindest zweier Schnappverbindungen an jedem Antennengehäuse 1 befestigt ist. Die Verbindungsplatte 20a ist vorzugsweise symmetrisch zu einem Mittelpunkt in der Verbindungsplatte 20a aufgebaut.
Das stiftförmige oder näherungsweise stiftförmig ausgebildete zumindest eine männliche Teil 8 weist benachbart zu seinen Kontaktstellen 10 noch einen Rand 11 mit einem verbreiterten Durchmesser auf. Benachbart dazu ist eine Unterbrechung 25 gebildet, wodurch das stiftförmig oder näherungsweise stiftförmig ausgebildete männliche Teil 8 in zwei voneinander getrennte Segmente 8a, 8b unterteilt ist.

Die Verbindungsplatte 20a ist zusammen mit den männlichen bzw. weiblichen Teilen 8, 9 einteilig ausgebildet. Die männlichen bzw. weiblichen Teile 8, 9 sind vorzugsweise im Eckbereich der Verbindungsplatte 20a angeordnet.

Die Verbindungsplatte 20a weist weiterhin Öffnungen 26 zum Einbringen einer Verbindungsschraube auf. Über diese Öffnungen 26 kann die Verbindungsplatte 20a an einem Grundkörper, wie beispielsweise an einer Oberfläche der "Stadtmöbel", befestigt werden.

Die Verbindungsplatte 20a weist an ihrer Oberseite 27 eine wabenförmige oder fachwerkähnliche Struktur auf, um einerseits Material bei der Herstellung der Verbindungsplatte 20a einzusparen und um andererseits die Stabilität zu erhöhen. Zudem wird hier ein kunststoffgerechtes Design verwendet, das bei der Teilefertigung gleichmäßige Wanddichten und eine optimale Verteilung des Materials im jeweiligen Bauteil ermöglicht.

Im montierten Zustand steht die Verbindungsplatte 20a nicht über die deckelseitigen Stirnseiten 4 der Antennengehäuse 1 hervor. Die Antennengehäuse 1, welche Rücken-an-Rücken zueinander angeordnet sind, sind durch die Verbindungsplatte 20a derart weit voneinander beabstandet, dass die Anschlusskabel noch angeschlossen werden können. Die Verbindungsplatte 20a kann zusätzlich eine durchgehende Öffnung aufweisen, durch die diese Anschlusskabel geführt werden können.

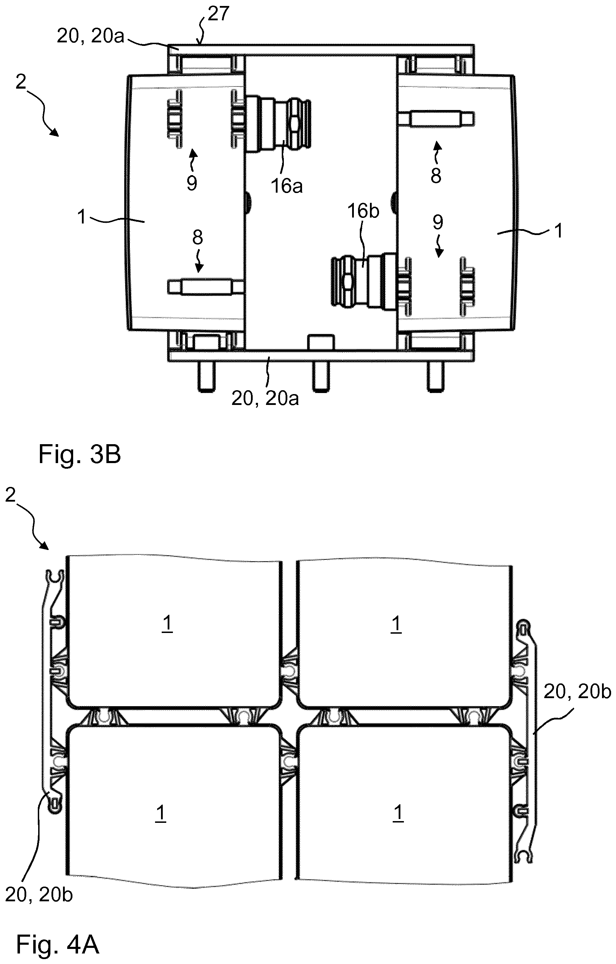

Figur 3B zeigt eine seitliche Darstellung der modularen Gehäuseanordnung 2 aus Figur 3A mit zwei Antennengehäusen 1, die Rücken-an-Rücken zueinander angeordnet sind.

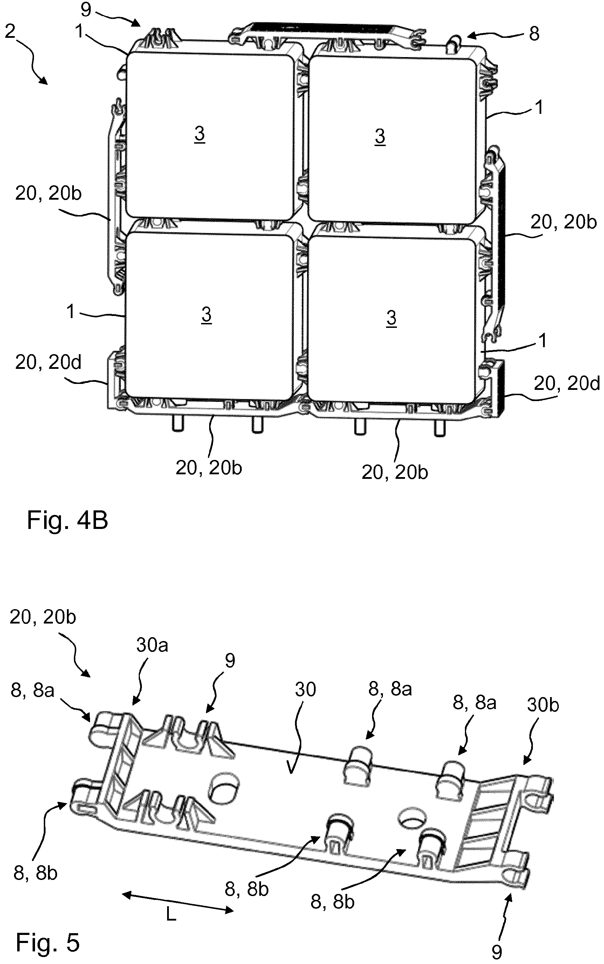

Figur 4A zeigt eine weitere Darstellung, die verdeutlicht, wie einzelne Antennengehäuse 1 unmittelbar miteinander verbunden sein können. Die modulare Gehäuseanordnung 2 aus Figur 4A, welche in Figur 4B in einer Übersichtsdarstellung dargestellt ist, weist eine Konfiguration von 2x2-Antennengehäusen 1 auf. Jedes Antennengehäuse 1 ist mit zwei anderen Antennengehäusen 1 verbunden. Eine unmittelbare Verbindung liegt dann vor, wenn die männlichen bzw. weiblichen Teile 8, 9 eines Antennengehäuses 1 in die dazu korrespondierenden weiblichen bzw. männlichen Teile 9, 8 eines anderen Antennengehäuses 1 direkt unter Bildung einer Schnappverbindung eingreifen. Ein solcher Fall ist mit Figur 4A gezeigt.

Bei den dargestellten Schnappverbindungen handelt es sich um Ringschnappverbindungen. Die einzelnen Antennengehäuse 1, insbesondere die deckelseitigen Stirnseiten 3 der einzelnen Antennengehäuse 1, sind in einem Winkel von 0° zueinander angeordnet. Dies bedeutet, dass die deckelseitigen Stirnseiten 3 der einzelnen Antennengehäuse 1 in einer gemeinsamen Ebene liegen. Die Antennen 7 innerhalb der einzelnen Antennengehäuse 1 strahlen dabei in etwa in die gleiche Richtung ab.

In den Figuren 4A und 4B sind außerdem noch Verbindungselemente 20 in Form von Verstärkungselementen 20b dargestellt.

Figur 5 zeigt eine vergrößerte Darstellung eines solchen Verstärkungselements 20b. Das Verstärkungselement 20b weist an einer ersten Seitenfläche 30, vorzugsweise nur an genau der einen ersten Seitenfläche 30, zumindest ein männliches Teil 8 und zumindest ein weibliches Teil 9 einer Schnappverbindung auf, die über die Länge des Verstärkungselements 20b versetzt zueinander angeordnet sind. Das Verstärkungselement 20b ist mit Hinblick auf die Figur 4A mit zwei Antennengehäusen 1 verbunden. Hierzu greift das männliche Teil 8 des Verstärkungselements 20b in ein weibliches Teil 9 des ersten Antennengehäuses 1 ein. Dazu korrespondierend greift ein männliches Teil 8 des zweiten Antennengehäuses 1 in ein weibliches Teil 9 des Verstärkungselements 20b ein. Das Verstärkungselement 20b verbindet daher zwei Seitenflächen 5a, 5b, 5c, 5d von verschiedenen Antennengehäusen 1, die in der gleichen Ebene liegen. Dies bedeutet, dass das weibliche Teil 9 des ersten Antennengehäuses 1 und das männliche Teil 8 des zweiten Antennengehäuses 1 in einer gemeinsamen Ebene liegen.

In Figur 4B ist außerdem dargestellt, dass das Verstärkungselement 20b ausschließlich mit einer Seitenfläche 5a, 5b, 5c, 5d des Antennengehäuses 1 verbunden ist. In diesem Fall ist das männliche Teil 8 des Verstärkungselements 20b in ein weibliches Teil 9 des Antennengehäuses 1 eingeführt und weiterhin ist ein männliches Teil 8 des gleichen Antennengehäuses 1 in ein weibliches Teil 9 des Verstärkungselements 20b eingeführt. Ein solches Verstärkungselement 20b ist im unteren Bereich der modularen Gehäuseanordnung 2 aus Figur 4B gezeigt.

Das zumindest eine Verstärkungselement 20b aus Figur 5 weist weiterhin an einer ersten Stirnseite 30a ein männliches Teil 8 auf, wohingegen an einer zweiten Stirnseite 30b, die gegenüberliegend zur ersten Stirnseite 30a angeordnet ist, ein weibliches Teil 9 einer Schnappverbindung ausgebildet ist. Die männlichen bzw. weiblichen Teile 8, 9, die an einer der beiden Stirnseiten 30a, 30b des Verstärkungselements 20b ausgebildet sind, sind in einem Winkel von ungefähr 90° versetzt zu den männlichen bzw. weiblichen Teilen 8, 9 angeordnet, die an der ersten Seitenfläche 30 des Verstärkungselements 20b angeordnet sind. Die männlichen Teile 8 bestehen, wie im Hinblick auf Figur 2 erläutert, aus zwei verschiedenen Segmenten 8a, 8b.

Für den Fall, dass das Verstärkungselement 20b mit seinen männlichen bzw. weiblichen Teilen 8, 9, die an seiner ersten Seitenfläche 30 ausgebildet sind, ausschließlich mit einer Seitenfläche 5a, 5b, 5c, 5d genau eines Antennengehäuses 1 verbunden sind, können die männlichen bzw. weiblichen Teile 8, 9, die an den Stirnseiten 30a, 30b ausgebildet sind, in die dazu korrespondierenden weiblichen bzw. männlichen Teile 9, 8 eingreifen, die in einem anderen Verstärkungselement 20b an dessen Stirnseite ausgebildet sind, welches mit genau einem anderen Antennengehäuse verbunden ist. Ein solcher Fall ist im unteren Bereich der modularen Gehäuseanordnung 2 aus Figur 4B gezeigt. Die beiden Verstärkungselemente 20b, die miteinander verbunden sind, liegen in einer gemeinsamen Ebene und sind jeweils mit genau einem Antennengehäuse 1 verbunden.

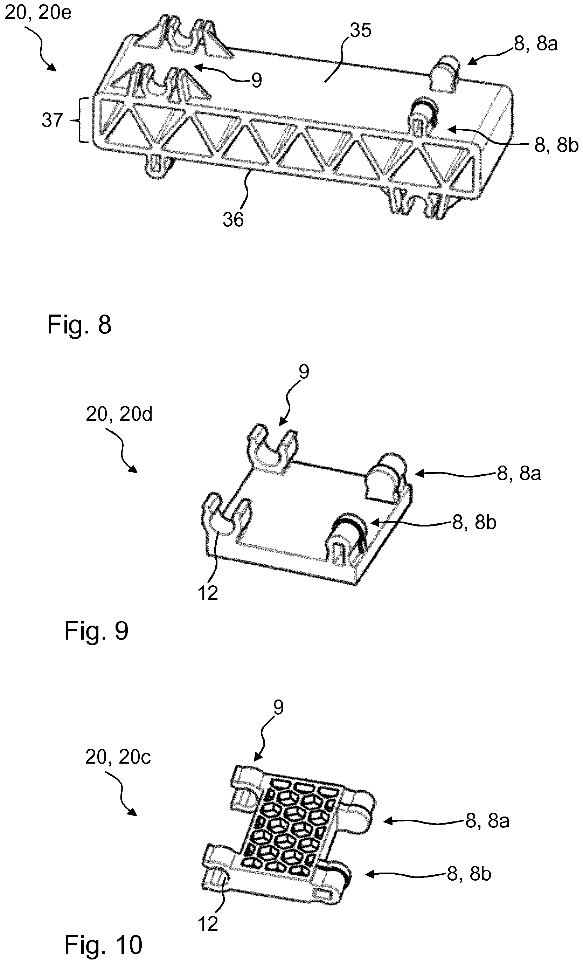

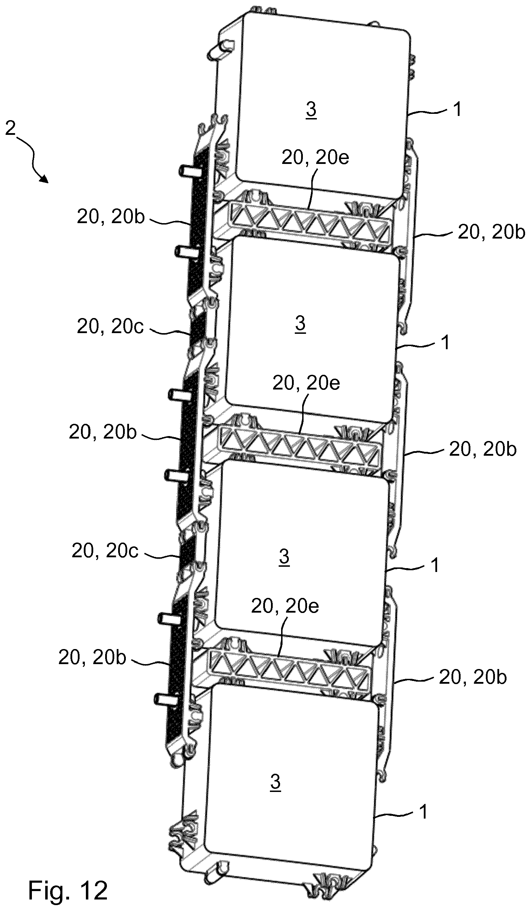

Mit Hinblick auf Figur 12, die ebenfalls eine modulare Gehäuseanordnung 2 zeigt, deren Antennengehäuse 1 mit einer Konfiguration von 4x1 angeordnet sind, gibt es noch ein zusätzliches Verbindungselement 20 in Form eines Zwischenverbinders 20c. Ein solcher Zwischenverbinder 20c ist in Figur 10 gezeigt. Der Zwischenverbinder 20c weist an beiden Stirnseiten je ein männliches und ein weibliches Teil 8, 9 auf. Bei einer mittelbaren Verbindung, die im Folgenden noch erläutert wird, zwischen zwei Antennengehäusen 1, ist eine direkte Verbindung zwischen zwei Verstärkungselementen 20b nicht möglich. Das männliche Teil 8 an der Stirnseite des einen Verstärkungselements 20b greift in das zumindest eine weibliche Teil 9 des Zwischenverbinders 20c ein, wobei das zumindest eine männliche Teil 8 des Zwischenverbinders 20c in das weibliche Teil 9 an der Stirnseite des anderen Verstärkungselements 20b eingreift.

Sowohl der Zwischenverbinder 20c als auch das Verstärkungselement 20b können an ihrer Oberfläche, an der kein männliches bzw. weibliches Teil 8, 9 angeordnet ist, eine wabenförmige oder fachwerkähnliche Struktur aufweisen.

Der Zwischenverbinder 20c weist eine kleinere Länge auf als das Verstärkungselement 20b. Der Zwischenverbinder 20c weist eine rechteckförmige Grundstruktur auf.

Das Verstärkungselement 20b steht, wenn es einzig mit einer Seitenfläche 5a, 5b, 5c, 5d eines Antennengehäuses 1 verbunden ist, über diese Seitenfläche 5a, 5b, 5c, 5d mit seiner Stirnseite 30a, 30b und damit mit den dort angebrachten männlichen bzw. weiblichen Teilen 8, 9 vor.

In Figur 4B ist außerdem noch ein Verbindungselement 20 in Form eines Winkelverbinders 20d gezeigt. Figur 9 zeigt den Winkelverbinder 20d in einer vergrößerten Darstellung. Der Winkelverbinder 20d weist eine reckteckförmige Grundstruktur auf, wobei an dieser ein männliches und ein weibliches Teil 8, 9 angebracht sind. Beide Teile sind jeweils an den Ecken des Winkelverbinders 20d angebracht. Beide Teile 8, 9 sind an der gleichen Seite des Winkelverbinders 20d angebracht. Der zumindest eine Winkelverbinder 20d greift mit seinem männlichen bzw. weiblichen Teil 8, 9 in das dazu korrespondierende weibliche bzw. männliche Teil 9, 8 des Verstärkungselements 20b ein, die an dessen Stirnseite 30a, 30b angeordnet sind. Der Winkelverbinder 20d greift außerdem mit seinem anderen weiblichen bzw. männlichen Teil 9, 8 in das männliche oder weibliche Teil 8, 9 einer weiteren Seitenfläche 5a, 5b, 5c, 5d der umlaufenden Seitenwand 5 des Antennengehäuses 1 ein, die zu der Seitenfläche 5a, 5b, 5c, 5d der umlaufenden Seitenwand 5 direkt benachbart ist, an der das Verstärkungselement 20b eingreift. Eine Oberfläche des Winkelverbinders 20d, an der das männliche bzw. weibliche Teil 8, 9 nicht angeordnet ist, weist eine wabenförmige oder fachwerkähnliche Struktur auf.

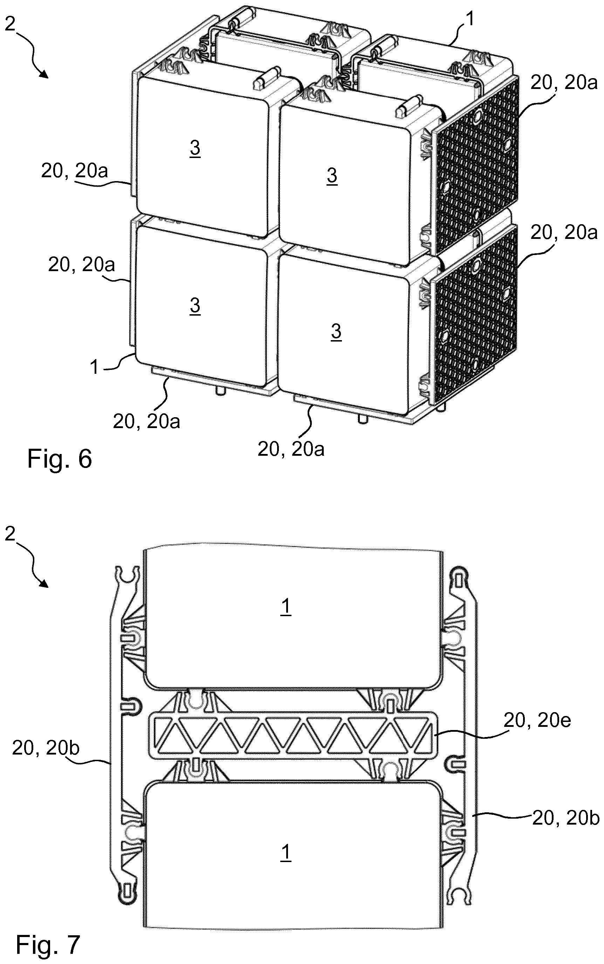

Figur 6 zeigt eine modulare Gehäuseanordnung 2, die mehrere Antennengehäuse 1 aufweist, wobei die Antennengehäuse 1 einerseits in einer 2x2-Konfiguration angeordnet sind und wobei zu dieser Konfiguration eine weitere 2x2-Konfiguration von Antennengehäusen 1 in einer Rücken-an-Rücken-Konfiguration angeordnet ist. Dies bedeutet, dass jeweils vier Antennen in eine erste Richtung und vier Antennen in eine zweite Richtung abstrahlen. Mehrere Verbindungsplatten 20a kommen zum Einsatz, um die einzelnen Antennengehäuse 1, die Rücken-an-Rücken zueinander angeordnet sind, aneinander zu fixieren.

Figur 7 zeigt eine weitere schematische Darstellung, die eine mittelbare Verbindung von zwei Antennengehäusen 1 beschreibt. In diesem Fall handelt es sich bei dem zumindest einen Verbindungselement 20 um einen Abstandshalter 20e. Dieser Abstandshalter 20e ist in Figur 8 in vergrößerter Darstellung dargestellt. Der Abstandshalter 20e weist zwei gegenüberliegende Seitenflächen 35, 36 auf, wobei auf jeder Seitenfläche 35, 36 zumindest ein männliches Teil 8 und zumindest ein weibliches Teil 9 einer Schnappverbindung über die Länge versetzt zueinander angeordnet sind. Beide Seitenflächen 35, 36 des Abstandshalters 20e sind durch ein integrales Zwischenteil 37 voneinander beabstandet. Das integrale Zwischenteil weist in seitlicher Draufsicht eine wabenförmige oder fachwerkähnliche Struktur auf. Zumindest ein männliches Teil 8 des ersten Antennengehäuses 1 greift in ein dazu korrespondierendes weibliches Teil 9 an der ersten Seite 35 des Abstandshalters 20e ein. Zumindest ein männliches Teil 8 des zweiten Antennengehäuses 1 greift in ein dazu korrespondierendes weibliches Teil 9 an der zweiten Seite 36 des Abstandshalters 20e ein. Weiterhin greift zumindest ein männliches Teil 8 auf der ersten Seite 35 des Abstandshalters 20e in ein dazu korrespondierendes weibliches Teil 9 an dem ersten Antennengehäuse 1 ein. Gleiches gilt auch für zumindest ein männliches Teil 8 auf der zweiten Seite 36 des Abstandshalters 20e, welches in ein dazu korrespondierendes weibliches Teil 9 an dem zweiten Antennengehäuse 1 eingreift, wodurch beide Antennengehäuse 1 mittelbar miteinander verbunden sind.

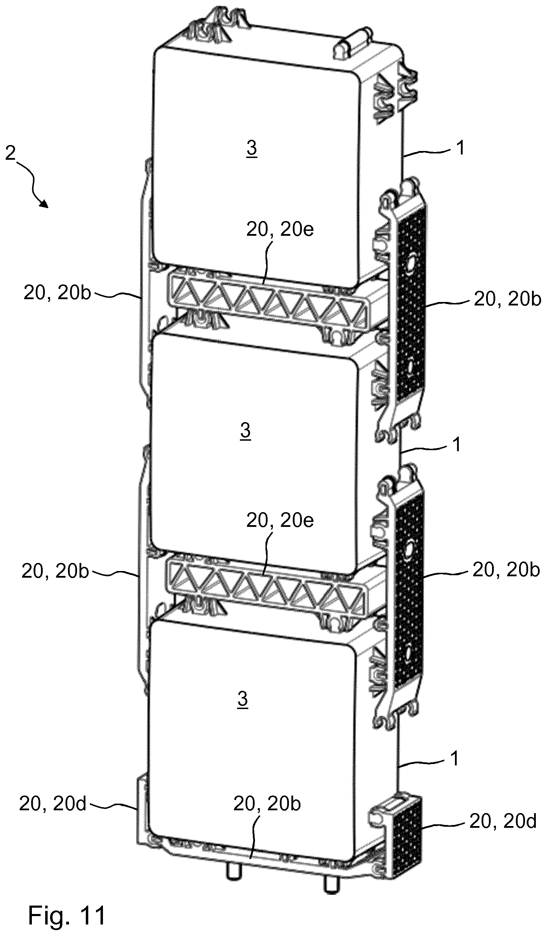

In den Figuren 11, 12, 13A und 13B sind ebenfalls modulare Gehäuseanordnungen 2 gezeigt, die einen Abstandshalter 20e aufweisen, über den zwei Antennengehäuse 1 mittelbar miteinander verbunden sind. Ein Abstandshalter 20e wird beispielsweise dann verwendet, wenn kein MIMO-Betrieb realisiert werden soll. Dies wäre beispielsweise dann der Fall, wenn die beiden miteinander verbundenen Antennengehäuse 1 von verschiedenen Mobilfunkanbietern betrieben werden würden. In diesem Fall wird durch den größeren Abstand der einzelnen Antennen 7 zueinander eine Störung zwischen diesen reduziert.

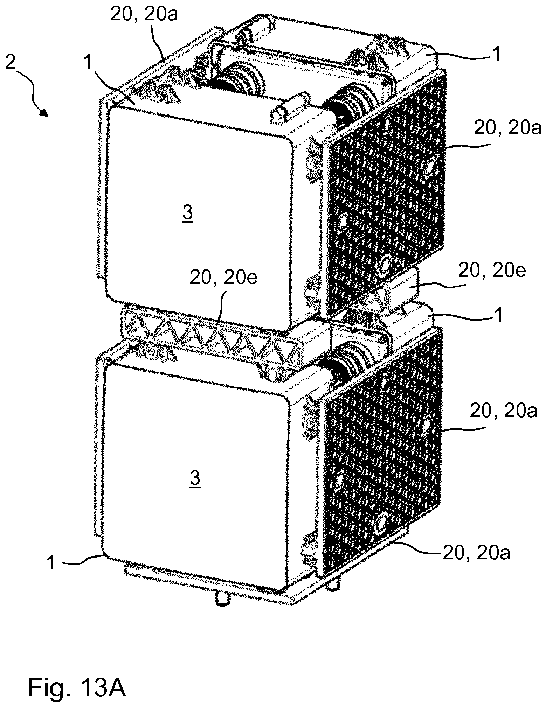

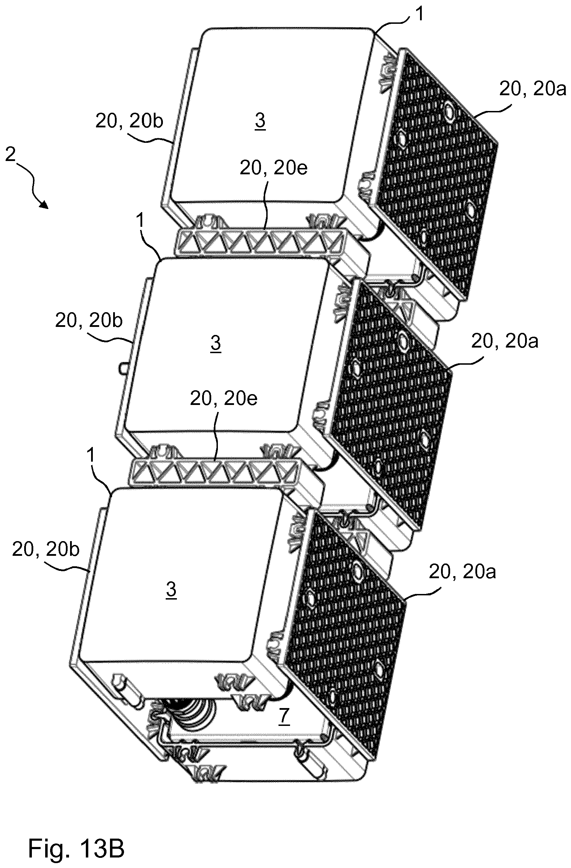

In Figur 11 weisen die Antennengehäuse 1 eine 3x1-Konfiguration auf. In Figur 12 ist es eine 4x1-Konfiguration. In Figur 13A handelt es sich um eine 2x-1-Konfiguration, die Rücken-an-Rücken mit einer weiteren 2x1-Konfiguration angeordnet ist. In Figur 13B handelt es sich um eine 3x1-Konfiguration, die Rücken-an-Rücken an eine weitere 3x-1-Konfiguration angeordnet ist. Es ist hier festzustellen, dass beliebig viele Antennengehäuse 1 auf diese Art und Weise miteinander verbunden werden können. Es wären daher AxB-Konfigurationen mit A und B ≥ 1 möglich, die optional Rücken-an-Rücken mit einer weiteren CxD-Konfiguration mit C und D ≥ 1 angeordnet sein können. Auch ein Versatz von 45° wäre möglich.

Figur 7 zeigt ebenfalls den Einsatz des Verstärkungselements 20b. Bei dem Verstärkungselement 20b handelt es sich vorzugsweise um ein "universelles" Verstärkungselement. Dies bedeutet, dass das Verstärkungselement 20b zwei Seitenflächen 5a, 5b, 5c, 5d von unterschiedlichen Antennengehäusen 1 immer verbinden kann, auch wenn diese Antennengehäuse 1 mittelbar oder unmittelbar miteinander verbunden sind. Hierzu weist das Verstärkungselement 20b an der ersten Seitenfläche 30 zumindest zwei versetzt zueinander angeordnete männliche und/oder weibliche Teile 8, 9 einer Schnappverbindung auf. Mit Hinblick auf Figur 5 sind zwei versetzt zueinander angeordnete männliche Teile 8 einer Schnappverbindung dargestellt. In Abhängigkeit davon, ob die beiden Antennengehäuse 1, deren Seitenflächen 5a, 5b, 5c, 5d durch das Verstärkungselement 20b miteinander verbunden werden sollen, mittelbar oder unmittelbar miteinander verbunden sind, gelangt das eine oder das andere der zumindest beiden versetzt über die Länge L zueinander angeordneten, in diesem Fall männlichen Teile 8, in Eingriff mit dem jeweiligen Gegenstück. Für den Fall, dass die beiden Antennengehäuse 1 lediglich mittelbar miteinander verbunden sind, gelangt das männliche Teil 8 auf der ersten Seitenfläche 30 des Verstärkungselements 20b in Eingriff mit einem weiblichen Teil 9 an der Seitenfläche 5a, 5b, 5c, 5d des Antennengehäuses 1, welches näher an einer Stirnseite 30a, 30b des Verstärkungselements 20b angeordnet ist. Bei einer unmittelbaren Verbindung beider Antennengehäuse 1 wird der männliche Teil 8 der Schnappverbindung verwendet, welcher von einer Stirnseite 30a, 30b des Verstärkungselements 20b weiter entfernt ist. Dies würde natürlich auch gelten, wenn es zwei weibliche Teile 9 und nur einen männlichen Teil 8 geben würde.
In den Figuren 14A bis 14C wird ein modifiziertes Verstärkungselement 20b verwendet. Dieses Verstärkungselement 20b weist auf seiner zweiten Seitenfläche 31, die der ersten Seitenfläche 30 gegenüber liegt, zumindest ein Kupplungsteil 32 einer Form- und/oder Kraftschlussverbindung auf. Dieses Kupplungsteil 32 ist in Kontakt mit einem Kupplungsteil 32 einer Form- und/oder Kraftschlussverbindung in einem anderen Verstärkungselement 20b gebracht. Beide Kupplungsteile 21 sind gegeneinander in einer Achse verdrehbar. Dadurch sind beide Verstärkungselemente 20b durch die beiden miteinander verbundenen Teile 32 über einen bestimmten Winkelbereich in festen Winkelschritten oder kontinuierlich gegeneinander verdrehbar. Das Kupplungsteil 32 einer Form- und/oder Kraftschlussverbindung ist hakenförmig ausgebildet, wobei die Kupplung zu dem anderen Kupplungsteil 32 jeweils am freien Ende ausgebildet ist. Die Antennengehäuse 1 können dadurch vorzugsweise um 120° gegeneinander verdreht werden. Die Drehachse verläuft durch die jeweiligen freien Enden der beiden Kupplungsteile 32. Es kann sich hier beispielsweise um eine Steckverbindung handeln.

Es können mehrere Verbindungselemente 20 verwendet werden, die sich aus der Menge der dargestellten Verbindungselemente 20 auswählen lassen, bei denen es sich um die Verbindungsplatte 20a, das Verstärkungselement 20b, den Zwischenverbinder 20c, den Winkelverbinder 20d oder den Abstandshalter 20e handelt. Es können dabei beliebig viele dieser Verbindungselemente 20 in beliebiger Kombination eingesetzt werden. Sämtliche Verbindungselemente 20 sind vorzugsweise einteilig ausgebildet. Sowohl das Antennengehäuse 1 als auch die Verbindungselemente 20 bestehen vorzugsweise aus einem Kunststoff.

Die Verbindungselemente 20 dienen vorzugsweise auch zum Befestigen der modularen Gehäuseanordnung 2 an einer nicht dargestellten Befestigungsplatte bzw. an den "Stadtmöbeln" selbst. Hierzu umfassen die Verbindungselemente 20 entsprechende Öffnungen, durch die eine Schraubverbindung geführt werden kann. Es ist auch möglich, dass die einzelnen Verbindungselemente 20 ein Gewinde aufweisen.

Die gesamte modulare Gehäuseanordnung 2 umfasst vorzugsweise ein nicht dargestelltes Außengehäuse, welches alle Antennengehäuse 1 mit den dazugehörigen Verbindungselementen 20 umgibt. Dieses Außengehäuse ist vorzugsweise wasserdicht.

Es ist auch möglich, dass das zumindest eine Antennengehäuse 1 mit dem zumindest einen männlichen und weiblichen Teil 8, 9 der Schnappverbindung an dazu korrespondierenden Teilen einer Grundstruktur und/oder Trägerplatte befestigbar sind, die Teil einer Gebäudestruktur, insbesondere Teil der "Stadtmöbel" sind.

Jeder Typ von Verbindungselement 20 weist vorzugsweise eine andere Farbe auf. Das Antennengehäuse 1 weist wiederum vorzugsweise eine andere Farbe auf verglichen mit den Verbindungselementen 20. Dadurch können Fehler beim Zusammenbau der modularen Gehäuseanordnung vermieden werden. Die unterschiedlichen Typen von Verbindungselementen 20 sind die Verbindungsplatte 20a, das Verstärkungselement 20b bzw. das modifizierte Verstärkungselementen 20b mit dem Kupplungsteil 32, der Zwischenverbinder 20c, der Winkelverbinder 20d und der Abstandshalter 20e.

Im Weiteren werden nochmals gesondert einige erfindungsgemäße Weiterbildungen der modularen Gehäuseanordnung 2 für Antennen 7 hervorgehoben, die auch als modulare Antennengehäuseanordnung 2 bezeichnet werden kann.

Ein Vorteil der modularen Gehäuseanordnung 2 für Antennen 7 besteht, wenn:
- das männliche und das weibliche Teil 8, 9 der Form- und/oder Kraftschlussverbindung an der umlaufenden Seitenwand 5 des zumindest einem Antennengehäuses in Umlaufrichtung versetzt zueinander angeordnet sind.

Ein Vorteil der modularen Gehäuseanordnung 2 für Antennen 7 besteht, wenn:
- die Form- und/oder Kraftschlussverbindung eine Schnappverbindung oder eine Schiebeverbindung oder eine Steckverbindung oder eine Bajonettverbindung oder eine Gelenkverbindung umfasst oder aus einer derartigen Verbindung besteht.

Ein zusätzlicher Vorteil der modularen Gehäuseanordnung 2 für Antennen 7 besteht, wenn:
- das stiftförmig oder näherungsweise stiftförmig ausgebildete zumindest eine männliche Teil 8 an seinen Kontaktstellen 10, die mit dem weiblichen Teil 9 in Kontakt bringbar oder gebracht sind, einen kleineren Durchmesser aufweist, als in den dazu axial benachbarten Stellen 11, wodurch eine relative axiale Verschiebung zwischen dem männlichen Teil 8 und dem weiblichen Teil 9 vermieden wird; oder
- das stiftförmig oder näherungsweise stiftförmig ausgebildete zumindest eine männliche Teil 8 benachbart zu seinen Kontaktstellen 10, die mit dem weiblichen Teil 9 in Kontakt bringbar oder gebracht sind, eine Unterbrechung 25 aufweist, wodurch zwei voneinander getrennte Segmente 8a, 8b gebildet sind.

Ein weiterer Vorteil der modularen Gehäuseanordnung 2 für Antennen 7 besteht, wenn:
- alle männlichen Teile 8 zumindest bezüglich der Anordnung und den Abmessungen ihrer Kontaktstellen 10 identisch zueinander aufgebaut sind.

Ein ergänzender Vorteil der modularen Gehäuseanordnung 2 für Antennen 7 besteht, wenn:
- die Schnappverbindung eine Ringschnappverbindung umfasst oder aus einer Ringschnappverbindung besteht.

Ein überraschender Vorteil der modularen Gehäuseanordnung 2 für Antennen 7 besteht, wenn:
- das zumindest eine männliche Teil 8 und das zumindest eine weibliche Teil 9:
   a) weiter von der bodenseitigen Stirnseite 4 weg angeordnet sind als von der deckelseitigen Stirnseite 3; oder
   b) weiter von der deckelseitigen Stirnseite 3 weg angeordnet sind als von der bodenseitigen Stirnseite 4; oder
   c) gleich weit von der bodenseitigen Stirnseite 4 weg angeordnet sind wie von der deckelseitigen Stirnseite 3.

Ein anderer Vorteil der modularen Gehäuseanordnung 2 für Antennen 7 besteht, wenn:
- das zumindest eine Antennengehäuse 1 an der deckelseitigen Stirnseite 3 überwiegend oder vollständig mit einer Abdeckung 15 geschlossen ist; und/oder
- das zumindest eine Antennengehäuse 1 an der bodenseitigen Stirnseite 4 überwiegend oder vollständig geöffnet oder mit einer weiteren Abdeckung 17 geschlossen ist.

Ein großer Vorteil der modularen Gehäuseanordnung 2 für Antennen 7 besteht außerdem, wenn:
- das zumindest eine Antennengehäuse 1 und/oder das zumindest eine Verbindungselement 20 aus Kunststoff besteht oder Kunststoff umfasst.

Ein weiterer Vorteil der modularen Gehäuseanordnung 2 für Antennen 7 besteht, wenn:
- zumindest ein männliches Teil 8 jedes der beiden Antennengehäuse 1 in ein dazu korrespondierendes weibliches Teil 9 am anderen Antennengehäuse 1 eingreift, wodurch beide Antennengehäuse 1 durch die Form- und/oder Kraftschlussverbindung unmittelbar miteinander verbunden sind.

Ein ergänzender Vorteil der modularen Gehäuseanordnung 2 für Antennen 7 besteht, wenn:
- die Verbindungsplatte 20a zumindest zwei männliche und zwei weibliche Teile 8, 9 einer Form- und/oder Kraftschlussverbindung aufweist;
- ein männliches Teil 8 des ersten Antennengehäuses 1 in das weibliche Teil 9 der Verbindungsplatte 20a eingreift;
- ein männliches Teil 8 der Verbindungsplatte 20a in das weibliche Teil 9 des ersten Antennengehäuses 1 eingreift;
- ein männliches Teil 8 des zweiten Antennengehäuses 1 in das weibliche Teil 9 der Verbindungsplatte 20a eingreift;
- ein männliches Teil 8 der Verbindungsplatte 20a in das weibliche Teil 9 des zweiten Antennengehäuses 1 eingreift.

Außerdem besteht ein Vorteil bei der modularen Gehäuseanordnung 2 für Antennen 7, wenn:
- die modulare Gehäuseanordnung 2 ein Außengehäuse umfasst;
- das Außengehäuse alle Antennengehäuse 1 gemeinsam umgibt.

Die Erfindung ist nicht auf die beschriebenen Ausführungsbeispiele beschränkt. Im Rahmen der Erfindung sind alle beschriebenen und/oder gezeichneten Merkmale beliebig miteinander kombinierbar.

## Patentansprüche

1. Modulare Gehäuseanordnung (2) für Antennen (7) mit den folgenden Merkmalen:
- zumindest einem Antennengehäuse (1);
- das zumindest eine Antennengehäuse (1) umfasst eine deckelseitige Stirnseite (3), eine bodenseitige Stirnseite (4) und eine zwischen der deckelseitigen Stirnseite (3) und der bodenseitigen Stirnseite (4) umlaufende Seitenwand (5) mit mehreren Seitenflächen (5a, 5b, 5c, 5d), wodurch ein Aufnahmeraum (6) definiert ist;
- zumindest eine Antenne (7) ist in dem Aufnahmeraum (6) angeordnet oder anordenbar;
- an der umlaufenden Seitenwand (5) sind zumindest ein männliches und ein weibliches Teil (8, 9) einer Form- und/oder Kraftschlussverbindung angeordnet;
- das zumindest eine männliche Teil (8) und das zumindest eine weibliche Teil (9) sind dazu ausgebildet eine lösbare Form- und/oder Kraftschlussverbindung mit einem dazu korrespondierenden weiblichen bzw. männlichen Teil (9, 8) zumindest eines weiteren Antennengehäuses (1) und/oder zumindest eines Verbindungselements (20) herzustellen; und
a) das zumindest eine männliche Teil (8) ist stiftförmig oder näherungsweise stiftförmig ausgebildet und das zumindest eine weibliche Teil (9) besteht aus einem U- und/oder klammerförmigen Aufnahmeelement (12) oder aus zumindest zwei in Axialrichtung voneinander beabstandeten U- und/oder klammerförmigen Aufnahmeelementen (12), wobei jedes U- und/oder klammerförmige Aufnahmeelement (12) aus zwei elastischen Halteschenkeln (12a, 12b) besteht, durch die das zumindest eine männliche Teil (8) formschlüssig haltbar ist oder gehalten ist;
oder
b) die lösbare Form- und/oder Kraftschlussverbindung umfasst eine Gelenkverbindung.

2. Modulare Gehäuseanordnung (2) nach Anspruch 1, **gekennzeichnet durch** das folgende Merkmal:
- das zumindest eine weibliche Teil (9) weist einen oder zumindest zwei Schnappschutzelemente (13) auf, die ein Überdehnen des ersten und/oder zweiten Halteschenkels (12a, 12b) beim Ein- und/oder Ausklipsen des männlichen Teils (8) verhindern.

3. Modulare Gehäuseanordnung (2) nach einem der vorherigen Ansprüche, **gekennzeichnet durch,** die folgenden Merkmale:
- das zumindest eine Antennengehäuse (1) weist die Form eines n-Ecks mit n ≥ 4 auf, wobei an den meisten oder allen der n Seitenflächen (5a, 5b, 5c, 5d) der umlaufenden Seitenwand (5) zumindest ein männliches Teil (8) und zumindest ein weibliches Teil (9) der Form- und/oder Kraftschlussverbindung angeordnet sind; und/oder
- das zumindest eine männliche Teil (8) ist einteilig oder mehrteilig ausgebildet; und das zumindest eine Antennengehäuse (1) ist einteilig mit den männlichen und weiblichen Teilen (8, 9) ausgebildet, die an diesem angeordnet sind.

4. Modulare Gehäuseanordnung (2) nach einem der vorherigen Ansprüche, **gekennzeichnet durch** die folgenden Merkmale:
- die modulare Gehäuseanordnung (2) umfasst zumindest zwei Antennengehäuse (1), die über ihre jeweiligen männlichen und weiblichen Teile (8, 9) der Form- und/oder Kraftschlussverbindung mittelbar oder unmittelbar miteinander verbindbar sind oder verbunden sind; und/oder
- Ebenen der deckelseitigen Stirnseiten (3) der einzelnen Antennengehäuse (1) sind in einem Winkel von 0°, 90° und/oder 180° oder in einem Winkel dazwischen zueinander angeordnet.

5. Modulare Gehäuseanordnung (2) nach Anspruch 4, **gekennzeichnet durch** die folgenden Merkmale:
- das zumindest eine Verbindungselement (20) besteht aus einem Abstandshalter (20e) oder umfasst einen solchen;
- der Abstandshalter (20e) weist zwei gegenüberliegende Seitenflächen (35, 36) auf, wobei auf jeder Seitenfläche (35, 36) zumindest ein männliches Teil (8) und zumindest ein weibliches Teil (9) einer Form- und/oder Kraftschlussverbindung versetzt zueinander angeordnet sind;
- beide Seitenflächen (35, 36) des Abstandshalter (20e) sind durch ein integrales Zwischenteil (37) voneinander beabstandet;
- zumindest ein männliches Teil (8) des ersten Antennengehäuses (1) greift in ein dazu korrespondierendes weibliches Teil (9) an der ersten Seite (35) des Abstandshalters (20e) ein;
- zumindest ein männliches Teil (8) des zweiten Antennengehäuses (1) greift in ein dazu korrespondierendes weibliches Teil (9) an der zweiten Seite (36) des Abstandshalters (20e) ein;
- zumindest ein männliches Teil (8) auf der ersten Seite (35) des Abstandshalters (20e) greift in ein dazu korrespondierendes weibliches Teil (9) an dem ersten Antennengehäuse (1) ein;
- zumindest ein männliches Teil (8) auf der zweiten Seite (36) des Abstandshalters (20e) greift in ein dazu korrespondierendes weibliches Teil (9) an dem zweiten Antennengehäuse (1) ein, wodurch beide Antennengehäuse (1) mittelbar miteinander verbunden sind.

6. Modulare Gehäuseanordnung (2) nach einem der Ansprüche 4 oder 5, **gekennzeichnet durch** die folgenden Merkmale:
- das zumindest eine Verbindungselement (20) umfasst zumindest ein Verstärkungselement (20b) oder besteht aus einem solchen;
- das Verstärkungselement (20b) weist an einer ersten Seitenfläche (30) zumindest ein männliches Teil (8) und zumindest ein weibliches Teil (9) einer Form- und/oder Kraftschlussverbindung auf, die versetzt zueinander angeordnet sind;
- das Verstärkungselement (20b) ist
a) mit beiden Antennengehäusen (1) verbunden, indem das männliche Teil (8) des Verstärkungselements (20b) in ein weibliches Teil (9) des ersten Antennengehäuses (1) eingreift und indem ein männliches Teil (8) des zweiten Antennengehäuses (1) in ein weibliches Teil (9) des Verstärkungselements (20b) eingreift, wobei das weibliche Teil (9) des ersten Antennengehäuses (1) und das männliche Teil (8) des zweiten Antennengehäuses (1) in einer gemeinsamen Ebene liegen;
und/oder
b) mit einer Seitenfläche (5a, 5b, 5c, 5d) des Antennengehäuse (1) verbunden, indem das männliche Teil (8) des Verstärkungselements (20b) in ein weibliches Teil (9) des Antennengehäuses (1) eingreift und indem ein männlicher Teil (8) des Antennengehäuses (1) in ein weibliches Teil (9) des Verstärkungselements (20b) eingreift.

7. Modulare Gehäuseanordnung (2) nach Anspruch 6, **gekennzeichnet durch** das folgende Merkmal:
- das zumindest eine Verstärkungselement (20b) weist an einer ersten Stirnseite ein männliches Teil (8) und an einer zweiten Stirnseite ein weibliches Teil (9) einer Form- und/oder Kraftschlussverbindung auf.

8. Modulare Gehäuseanordnung (2) nach Anspruch 7, **gekennzeichnet durch** die folgenden Merkmale:
- die modulare Gehäuseanordnung (2) umfasst zumindest zwei oder zumindest drei über- und/oder nebeneinander angeordnete Antennengehäuse (1), die mittelbar oder unmittelbar miteinander verbunden sind, wobei bevorzugt die deckelseitigen Stirnseiten (3) der Antennengehäuse (1) in einer Ebene liegen;
- zwei Verstärkungselemente (20b), die in einer gemeinsamen Ebene liegen und mit einem Antennengehäuse (1) oder zwei Antennengehäusen (1) verbunden sind, sind zusätzlich miteinander verbunden, indem:
a) der männliche Teil (8) an der Stirnseite (30a, 30b) des einen Verstärkungselements (20b) in den weiblichen Teil (9) der Stirnseite (30b, 30a) des anderen Verstärkungselements (20b) unter Bildung einer Form- und/oder Kraftschlussverbindung eingreift; oder
b) der männliche Teil (8) an der Stirnseite (30a, 30b) des einen Verstärkungselements (20b) in zumindest einen weiblichen Teil (9) eines Zwischenverbinders (20c) eingreift, wobei zumindest ein männlicher Teil (9) des Zwischenverbinders (20c) in den weiblichen Teil (9) an der Stirnseite (30b, 30a) des anderen Verstärkungselements (20b) eingreift.

9. Modulare Gehäuseanordnung (2) nach einem der Ansprüche 6 bis 8, **gekennzeichnet durch** das folgende Merkmal:
- das Verstärkungselement (20b) weist an einer zweiten Seitenfläche (31), die der ersten Seitenfläche (30) gegenüberliegt, zumindest ein Kupplungsteil (32) einer Form- und/oder Kraftschlussverbindung auf, das in Kontakt mit einem Kupplungsteil (32) einer Form- und/oder Kraftschlussverbindung in einem anderen Verstärkungselement (20b) bringbar ist, wobei beide Verstärkungselemente (20b) durch die beiden miteinander verbundenen Kupplungsteile (32) über einen bestimmten Winkelbereich in festen Winkelschritten oder kontinuierlich gegeneinander verdrehbar sind.

10. Modulare Gehäuseanordnung (2) nach einem der Ansprüche 6 bis 9, **gekennzeichnet durch** die folgenden Merkmale:
- das zumindest ein Verbindungselement (20) umfasst zumindest einen Winkelverbinder (20d) oder besteht aus einem solchen;
- der zumindest eine Winkelverbinder (20d) weist an einer ersten Stirnseite ein männliches Teil (8) und an einer zweiten Stirnseite ein weibliches Teil (9) einer Form- und/oder Kraftschlussverbindung auf;
- der zumindest eine Winkelverbinder (20d) greift mit seinem männlichen bzw. weiblichen Teil (8, 9) an seiner ersten oder zweiten Stirnseite in das weibliche bzw. männliche Teil (9, 8) des Verstärkungselements (20b) ein, der an dessen erster oder zweiter Stirnseite (30a, 30b) angeordnet ist;
- der Winkelverbinder (20d) greift mit seinem weiblichen bzw. männlichen Teil (9, 8) an seiner zweiten oder ersten Stirnseite in das männliche oder weibliche Teil (8, 9) an einer weiteren Seitenfläche (5a, 5b, 5c, 5d) der umlaufenden Seitenwand (5) des Antennengehäuses (1) ein, die zu der Seitenfläche (5a, 5b, 5c, 5d) der umlaufenden Seitenwand (5) benachbart ist, an der das Verstärkungselement (20b) eingreift.

11. Modulare Gehäuseanordnung (2) nach einem der Ansprüche 6 bis 10, **gekennzeichnet durch** die folgenden Merkmale:
- das Verstärkungselement (20b) weist an der ersten Seitenfläche (30) über die Länge (L) zumindest zwei versetzt zueinander angeordnete männliche oder weibliche Teile (8, 9) einer Form- und/oder Kraftschlussverbindung auf;
- in Abhängigkeit davon, ob die beiden Antennengehäuse (1) mittelbar oder unmittelbar miteinander verbunden sind, gelangt das eine oder das andere der zumindest beiden männlichen oder weiblichen Teile (8, 9) in Eingriff mit dem jeweiligen Gegenstück.

12. Modulare Gehäuseanordnung (2) nach einem der Ansprüche 4 bis 11, **gekennzeichnet durch** die folgenden Merkmale:
- zumindest zwei Antennengehäuse (1) sind mit ihren bodenseitigen Stirnseiten (4) in Abstand zueinander angeordnet und aufeinander zu gerichtet;
- das zumindest eine Verbindungselement (20) umfasst eine Verbindungsplatte (20a) oder besteht aus einer solchen, die senkrecht zu den beiden deckelseitigen Stirnseiten (3) angeordnet ist;
- die Verbindungsplatte (20a) ist über eine Form- und/oder Kraftschlussverbindung mit den beiden Antennengehäusen (1) verbunden.

13. Modulare Gehäuseanordnung (2) nach Anspruch 5 oder nach Anspruch 12, **gekennzeichnet durch** die folgenden Merkmale:
- der Zwischenteil (37) des Abstandshalters (20e) weist eine wabenförmige oder fachwerkähnliche Struktur auf; und/oder
- die Verbindungsplatte (20a) weist eine wabenförmige oder fachwerkähnliche Struktur auf.

14. Modulare Gehäuseanordnung (2) nach einem der vorherigen Ansprüche, **gekennzeichnet durch** das folgende Merkmal:
- das zumindest eine Antennengehäuse (1) ist mit dem zumindest einen männlichen und weiblichen Teil (8, 9) der Form- und/oder Kraftschlussverbindung an dazu korrespondierenden Teilen einer Grundstruktur und/oder Trägerplatte befestigbar, die Teil einer Gebäudestruktur sind.

## Claims

1. Modular housing arrangement (2) for antennas (7) having the following features:
- at least one antenna housing (1);
- the at least one antenna housing (1) comprises a front face (3) on the cover side, a front face (4) on the base side and a peripheral side wall (5) between the front face (3) on the cover side and the front face (4) on the base side that comprises a plurality of lateral surfaces (5a, 5b, 5c, 5d), as a result of which a receiving space (6) is defined;
- at least one antenna (7) is or can be arranged in the receiving space (6);
- at least one male and one female part (8, 9) of a positive and/or non-positive connection are arranged on the peripheral side wall (5);
- the at least one male part (8) and the at least one female part (9) are designed to establish a detachable positive and/or non-positive connection to a corresponding female and male part (9, 8), respectively, of at least one further antenna housing (1) and/or of at least one connecting element (20); and
a) the at least one male part (8) is pin-shaped or approximately pin-shaped and the at least one female part (9) consists of a receiving element (12) in the shape of a U and/or a bracket, or of at least two receiving elements (12) in the shape of a U and/or a bracket that are spaced apart from one another in the axial direction, each receiving element (12) in the shape of a U and/or a bracket consisting of two resilient retaining legs (12a, 12b), by means of which the at least one male part (8) can be or is held in a positive manner;
or
b) the positive and/or non-positive connection comprises a hinged connection.

2. Modular housing arrangement (2) according to claim 1, **characterised by** the following feature:
- the at least one female part (9) has one or at least two snap protection elements (13) which prevent overstretching of the first and/or second retaining leg (12a, 12b) when the male part (8) is clipped in and/or out.

3. Modular housing arrangement (2) according to any of the preceding claims, **characterised by** the following feature:
- the at least one antenna housing (1) is in the shape of an n-gon where n ≥ 4, at least one male part (8) and at least one female part (9) of the positive and/or non-positive connection being arranged on most or all of the n lateral surfaces (5a, 5b, 5c, 5d) of the peripheral side wall (5);
and/or
- the at least one male part (8) is formed integrally or of multiple parts; and
the at least one antenna housing (1) is formed integrally with the male and female parts (8, 9) which are arranged thereon.

4. Modular housing arrangement (2) according to any of the preceding claims, **characterised by** the following features:
- the modular housing arrangement (2) comprises at least two antenna housings (1) which can be or are indirectly or directly interconnected by means of their respective male and female parts (8, 9) of the positive and/or non-positive connection; and/or
- planes of the front faces (3) on the cover side of the individual antenna housings (1) are arranged at an angle of 0°, 90° and/or 180° to one another or at an angle in between.

5. Modular housing arrangement (2) according to claim 4, **characterised by** the following features:
- the at least one connecting element (20) consists of a spacer (20e) or comprises such;
- the spacer (20e) has two opposing lateral surfaces (35, 36), at least one male part (8) and at least one female part (9) of a positive and/or non-positive connection being arranged on each lateral surface (35, 36) so as to be offset from one another;
- both lateral surfaces (35, 36) of the spacer (20e) are spaced apart from one another by an integral intermediate part (37);
- at least one male part (8) of the first antenna housing (1) engages in a corresponding female part (9) on the first side (35) of the spacer (20e);
- at least one male part (8) of the second antenna housing (1) engages in a corresponding female part (9) on the second side (36) of the spacer (20e);
- at least one male part (8) on the first side (35) of the spacer (20e) engages in a corresponding female part (9) on the first antenna housing (1);
- at least one male part (8) on the second side (36) of the spacer (20e) engages in a corresponding female part (9) on the second antenna housing (1), as a result of which both antenna housings (1) are indirectly interconnected.

6. Modular housing arrangement (2) according to any of claim 4 or 5, **characterised by** the following feature:
- the at least one connecting element (20) comprises at least one reinforcing element (20b) or consists of such;
- the reinforcing element (20b) has, on a first lateral surface (30), at least one male part (8) and at least one female part (9) of a positive and/or non-positive connection which are arranged so as to be offset from one another;
- the reinforcing element (20b) is
a) connected to both antenna housings (1), in that the male part (8) of the reinforcing element (20b) engages in a female part (9) of the first antenna housing (1) and in that a male part (8) of the second antenna housing (1) engages in a female part (9) of the reinforcing element (20b), the female part (9) of the first antenna housing (1) and the male part (8) of the second antenna housing (1) lying in a common plane;
and/or
b) connected to a lateral surface (5a, 5b, 5c, 5d) of the antenna housing (1), in that the male part (8) of the reinforcing element (20b) engages in a female part (9) of the antenna housing (1) and in that a male part (8) of the antenna housing (1) engages in a female part (9) of the reinforcing element (20b).

7. Modular housing arrangement (2) according to claim 6, **characterised by** the following feature:
- the at least one reinforcing element (20b) has a male part (8) of a positive and/or non-positive connection on a first front face and a female part (9) of a positive and/or non-positive connection on a second front face.

8. Modular housing arrangement (2) according to claim 7, **characterised by** the following feature:
- the modular housing arrangement (2) comprises at least two or at least three antenna housings (1) which are arranged on top of or next to one another and are indirectly or directly interconnected, the front faces (3) on the cover side of the antenna housing (1) preferably lying in one plane;
- two reinforcing elements (20b), which lie in a common plane and are connected to one antenna housing (1) or two antenna housings (1), are additionally interconnected in that:
a) the male part (8) on the front face (30a, 30b) of one reinforcing element (20b) engages in the female part (9) of the front face (30b, 30a) of the other reinforcing element (20b), establishing a positive and/or non-positive connection; or
b) the male part (8) on the front face (30a, 30b) of one reinforcing element (20b) engages in at least one female part (9) of an intermediate connector (20c), at least one male part (9) of the intermediate connector (20c) engaging in the female part (9) on the front face (30b, 30a) of the other reinforcing element (20b).

9. Modular housing arrangement (2) according to any of claims 6 to 8, **characterised by** the following feature:
- on a second lateral surface (31) which is opposite the first lateral surface (30) the reinforcing element (20b) has at least one coupling part (32) of a positive and/or non-positive connection which can be brought into contact with a coupling part (32) of a positive and/or non-positive connection in another reinforcing element (20b), the two reinforcing elements (20b) being rotatable relative to one another over a specified angle range in fixed angle steps or continuously by means of the two interconnected coupling parts (32).

10. Modular housing arrangement (2) according to any of claims 6 to 9, **characterised by** the following features:
- the at least one connecting element (20) comprises an angle connector (20d) or consists of such;
- the at least one angle connector (20d) has a male part (8) of a positive and/or non-positive connection on a first front face and a female part (9) of a positive and/or non-positive connection on a second front face;
- the male or female part (8, 9), respectively, on the first or second front face of the at least one angle connector (20d) engages in the female or male part (9, 8), respectively, of the reinforcing element (20b) which is arranged on the first or second front face (30a, 30b) thereof;
- the female or male part (9, 8), respectively, on the second or first front face of the angle connector (20d) engages in the male or female part (8, 9) on a further lateral surface (5a, 5b, 5c, 5d) of the peripheral side wall (5) of the antenna housing (1) which is adjacent to the lateral surface (5a, 5b, 5c, 5d) of the peripheral side wall (5) on which the reinforcing element (20b) engages.

11. Modular housing arrangement (2) according to any of claims 6 to 10, **characterised by** the following features:
- the reinforcing element (20b) has, on the first lateral surface (30), at least two male or female parts (8, 9) of a positive and/or non-positive connection that are arranged so as to be offset from one another over the length (L);
- depending on whether the two antenna housings (1) are interconnected indirectly or directly, one or other of the at least two male or female parts (8, 9) engages in the relevant mating part.

12. Modular housing arrangement (2) according to any of claims 4 to 11, **characterised by** the following features:
- at least two antenna housings (1) are arranged such that their front faces (4) on the base side are spaced apart from one another and oriented towards one another;
- the at least one connecting element (20) comprises a connecting plate (20a) or consists of such, which plate is arranged perpendicularly to the two front faces (3) on the cover side;
- the connecting plate (20a) is connected to the two antenna housings (1) by a positive and/or non-positive connection.

13. Modular housing arrangement (2) according to claim 5 or according to claim 12, **characterised by** the following features:
- the intermediate part (37) of the spacer (20e) has a honeycomb-like or lattice-like structure; and/or
- the connecting plate (20a) has a honeycomb-like or lattice-like structure.

14. Modular housing arrangement (2) according to any of the preceding claims, **characterised by** the following feature:
- the at least one antenna housing (1) can be attached by means of the at least one male and female part (8, 9) of the positive and/or non-positive connection to corresponding parts on a base structure and/or carrier plate which are part of a building structure.

## Revendications

1. Système de boîtier modulaire (2) pour antennes (7) doté des caractéristiques suivantes:
- au moins un boîtier d'antenne (1);
- l'au moins un boîtier d'antenne (1) comprend une face frontale côté couvercle (3), une face frontale côté fond (4) et une paroi latérale (5) avec plusieurs faces latérales (5a, 5b, 5c, 5d), parcourant la périphérie entre la face frontale coté couvercle (3) et la face frontale côté fond (4), définissant ainsi un espace de réception (6);
- au moins une antenne (7) est disposée ou peut être disposée dans l'espace de réception (6);
- au moins une partie mâle et une partie femelle (8, 9) d'un assemblage par complémentarité des formes et/ou par friction sont disposées sur la paroi latérale (5) périphérique;
- l'au moins une partie mâle (8) et l'au moins une partie femelle (9) sont conçues pour établir un assemblage par complémentarité des formes et/ou par friction avec une partie correspondante femelle, respectivement, mâle (9, 8) d'au moins un autre boîtier d'antenne (1) et/ou d'au moins un élément de liaison (20) ; et
a) l'au moins une partie mâle (8) est conçue en forme de stylet ou à peu près en forme de stylet, et l'au moins une partie femelle (9) est constituée d'un élément de réception en forme d'U et/ou de pince (12), ou à base d'au moins deux éléments de réception (12) en forme d'U et/ou de pinces espacés l'un de l'autre dans la direction axiale, où chaque élément de réception (12) en forme d'U ou en forme de pince est constitué de deux pattes de maintien (12a, 12b) élastiques par lesquelles l'au moins une partie mâle (8) peut être tenue ou est tenue par complémentarité des formes;
ou
b) la liaison par complémentarité des formes et/ou par friction comprend une liaison articulée.

2. Système de boîtier modulaire (2) selon la revendication 1, **caractérisé par** la caractéristique suivante:
- l'au moins une partie femelle (9) présente un ou au moins deux éléments encliquetables (13) qui empêchent un étirement de la première et/ou de la deuxième patte de maintien (12a, 12b) lors de l'encliquetage et/ou du désencliquetage de la partie mâle (8).

3. Système de boîtier modulaire (2) selon l'une des revendications précédentes, **caractérisé par** les caractéristiques suivantes:
- l'au moins un boîtier d'antenne (1) présente la forme d'un polyèdre à n côtés avec n ≥ 4, où au moins une partie mâle (8) et au moins une partie femelle (9) de l'assemblage par complémentarité des formes et/ou par friction sont disposées sur la plupart ou toutes les n faces latérales (5a, 5b, 5c, 5d) de la paroi latérale (5) périphérique ; et/ou
- l'au moins une partie mâle (8) est conçue en une partie ou en plusieurs parties ; et
l'au moins un boîtier d'antenne (1) est conçu en une partie avec les parties mâle et femelle (8, 9) qui sont disposées sur celui-ci.

4. Système de boîtier modulaire (2) selon l'une des revendications précédentes, **caractérisé par** les caractéristiques suivantes:
- le système de boîtier modulaire (2) comprend au moins deux boîtiers d'antennes (1) qui peuvent être reliés ou sont reliés directement ou indirectement ensemble par l'assemblage par complémentarité des formes et/ou par friction par le biais de leurs parties (8, 9) mâles et femelles respectives ; et/ou
- des plans des faces frontales côté couvercle (3) des boitiers d'antennes (1) individuels sont disposés avec un angle de 0 °, 90 ° et/ou 180 °, ou avec un angle entre ceux-ci.

5. Système de boîtier modulaire (2) selon la revendication 4, **caractérisé par** les caractéristiques suivantes:
- l'au moins un élément de liaison (20) est constitué d'un espaceur (20e) ou comprend un tel élément;
- l'espaceur (20e) présente deux surfaces latérales (35, 36) situées l'une en face de l'autre, où, sur chaque surface latérale (35, 36), au moins une partie mâle (8) et au moins une partie femelle (9) d'un assemblage par complémentarité des formes et/ou par friction sont disposées décalées les unes par rapport aux autres;
- les deux surfaces latérales (35, 36) de l'espaceur (20e) sont espacées l'une de l'autre par une partie intermédiaire (37) intégrale;
- au moins une partie mâle (8) du premier boîtier d'antenne (1) se met en prise dans une partie femelle (9) lui correspondant au niveau du premier côté (35) de l'espaceur (20e);
- au moins une partie mâle (8) du deuxième boîtier d'antenne (1) se met en prise dans une partie femelle (9) lui correspondant au niveau du deuxième côté (36) de l'espaceur (20e);
- au moins une partie mâle (8) sur le premier côté (35) de l'espaceur (20e) se met en prise dans une partie femelle (9) lui correspondant au niveau du premier boîtier d'antenne (1);
- au moins une partie mâle (8) sur le deuxième côté (36) de l'espaceur (20e) se met en prise dans une partie femelle (9) lui correspondant au niveau du deuxième boîtier d'antenne (1), les deux boîtiers d'antennes (1) étant ainsi directement reliés ensemble.

6. Système de boîtier modulaire (2) selon l'une des revendications 4 ou 5, **caractérisé par** les caractéristiques suivantes:
- l'au moins un élément de liaison (20) comprend au moins un élément de renfort (20b) ou est constitué d'un tel élément;
- l'élément de renfort (20b) présente au niveau d'une première surface latérale (30) au moins une partie mâle (8) et au moins une partie femelle (9) d'un assemblage par complémentarité des formes et/ou par friction qui sont disposées décalées les unes par rapport aux autres;
- l'élément de renfort (20b) est
a) relié avec les deux boîtiers d'antennes (1), en ce que la partie mâle (8) de l'élément de renfort (20b) se met en prise dans une partie femelle (9) du premier boîtier d'antenne (1) et en ce qu'une partie mâle (8) du deuxième boîtier d'antenne (1) se met en prise dans une partie femelle (9) de l'élément de renfort (20b), où la partie femelle (9) du premier boîtier d'antenne (1) et la partie mâle (8) du deuxième boîtier d'antenne (1) se situent dans un plan commun;
et/ou
b) est relié avec une surface latérale (5a, 5b, 5c, 5d) du boîtier d'antenne (1) en ce que la partie mâle (8) de l'élément de renfort (20b) se met en prise dans une partie femelle (9) du boîtier d'antenne (1) et en ce qu'une partie mâle (8) du boîtier d'antenne (1) se met en prise dans une partie femelle (9) de l'élément de renfort (20b).

7. Système de boîtier modulaire (2) selon la revendication 6, **caractérisé par** la caractéristique suivante:
- l'au moins un élément de renfort (20b) présente, au niveau d'une première face frontale, une partie mâle (8), et au niveau d'une deuxième face frontale, une partie femelle (9) d'un assemblage par complémentarité des formes et/ou par friction.

8. Système de boîtier modulaire (2) selon la revendication 7, **caractérisé par** les caractéristiques suivantes:
- le système de boîtier modulaire (2) comprend au moins deux ou au moins trois boîtiers d'antennes (1) disposés les uns au-dessus des autres et/ou les uns à côté des autres, qui sont reliés directement ou indirectement ensemble, où, de préférence, les faces frontales côté couvercle (3) des boitiers d'antennes (1) se situent dans un plan;
- deux éléments de renfort (20b) qui se situent dans un même plan et sont reliés avec un boîtier d'antenne (1) ou deux boîtiers d'antennes (1), sont en outre reliés entre eux, en ce que:
a) la partie mâle (8) au niveau de la face frontale (30a, 30b) de l'élément de renfort (20b) se met en prise dans la partie femelle (9) de la face frontale (30b, 30a) de l'autre élément de renfort (20b), moyennant la formation d'un assemblage par complémentarité des formes et/ou par friction;
ou
b) la partie mâle (8) au niveau de la face frontale (30a, 30b) d'un élément de renfort (20b) donné se met en prise dans au moins une partie femelle (9) d'un connecteur intermédiaire (20c), où au moins une partie mâle (9) du connecteur intermédiaire (20c) se met en prise dans la partie femelle (9) sur la face frontale (30b, 30a) de l'autre élément de renfort (20b).

9. Système de boîtier modulaire (2) selon l'une des revendications 6 à 8, **caractérisé par** la caractéristique suivante:
- l'élément de renfort (20b) présente, au niveau d'une deuxième surface latérale (31), qui est opposée à la première surface latérale (30), au moins une partie de couplage (32) d'un assemblage par complémentarité des formes et/ou par friction qui peut être mise en contact avec une partie de couplage (32) d'un assemblage par complémentarité des formes et/ou par friction dans un autre élément de renfort (20b), les deux éléments de renfort (20b) pouvant être mis en rotation l'un par rapport à l'autre par les deux parties de couplage (32) liées ensemble sur une plage angulaire définie par des pas angulaires fixes ou de manière continue.

10. Système de boîtier modulaire (2) selon l'une des revendications 6 à 9, **caractérisé par** les caractéristiques suivantes:
- l'au moins un élément de liaison (20) comprend au moins un dispositif d'angle de liaison (20d) ou en constitué d'un tel dispositif;
- l'au moins un dispositif d'angle de liaison (20d) présente au niveau d'une première face frontale une partie mâle (8) et au niveau d'une deuxième face frontale une partie femelle (9) d'un assemblage par complémentarité des formes et/ou par friction;
- l'au moins un dispositif d'angle de liaison (20d) se met en prise avec sa partie mâle, respectivement femelle (8, 9) au niveau de sa première ou deuxième face frontale dans la partie femelle, respectivement, mâle (9, 8) de l'élément de renfort (20b), qui est disposé au niveau de sa première ou deuxième face frontale (30a, 30b);
- le dispositif d'angle de liaison (20d) se met en prise avec sa partie femelle, respectivement mâle (9, 8), au niveau de sa deuxième ou première face frontale, dans la partie mâle, respectivement, femelle (8, 9) au niveau d'une autre surface latérale (5a, 5b, 5c, 5d) de la paroi latérale (5) périphérique du boîtier d'antenne (1), qui est voisine de la surface latérale (5a, 5b, 5c, 5d) de la paroi latérale (5) périphérique, dans laquelle l'élément de renfort (20b)se met en prise.

11. Système de boîtier modulaire (2) selon l'une des revendications 6 à 10, **caractérisé par** les caractéristiques suivantes:
- l'élément de renfort (20b) présente, au niveau de la première surface latérale (30), sur la longueur (L), au moins deux parties mâles ou femelles (8, 9) d'un assemblage par complémentarité des formes et/ou par friction disposées décalées l'une par rapport à l'autre;
- en fonction du fait que les deux boîtiers d'antennes (1) se trouvent reliés ensemble directement ou indirectement, l'une ou l'autre des au moins deux parties mâles ou femelles (8, 9) se met en prise avec la pièce complémentaire respective.

12. Système de boîtier modulaire (2) selon l'une des revendications 4 à 11, **caractérisé par** les caractéristiques suivantes:
- au moins deux boîtiers d'antenne (1) sont disposés à distance l'un par rapport à l'autre et dirigés l'un vers l'autre avec leurs faces frontales (4) côté fond;
- l'au moins un élément de liaison (20) comprend une plaque de liaison (20a), ou est constitué d'une telle plaque, qui est disposée verticalement par rapport aux faces frontales (3) côté couvercle;
- la plaque de liaison (20a) est reliée avec les deux boîtiers d'antennes (1) par le biais d'un assemblage par complémentarité des formes et/ou par friction.

13. Système de boîtier modulaire (2) selon la revendication 5 ou la revendication 12, **caractérisé par** les caractéristiques suivantes:
- la pièce intermédiaire (37) de l'espaceur (20e) présente une structure alvéolaire ou en treillis;
et/ou
- la plaque de liaison (20a) présente une structure alvéolaire ou en treillis.

14. Système de boîtier modulaire (2) selon l'une des revendications précédentes, **caractérisé par** la caractéristique suivante:
- l'au moins un boîtier d'antenne (1) peut être fixé avec au moins une partie mâle et une partie femelle (8, 9) de l'assemblage par complémentarité des formes et/ou par friction à des parties lui correspondant d'une structure de base, et/ou d'une plaque de base, qui font partie d'une structure de bâtiment.
